# EUROPEAN PATENT APPLICATION

(11) **EP 4 421 129 A1**
(43) Date of publication of application: **28.08.2024**
(21) Application number: 22883338.0
(22) Date of filing: 04.10.2022
(51) Int. Cl.: C08L 101/00, C08K 3/01, H05K 1/16, H05K 3/00

(54) **RESIN COMPOSITION**

(30) Priority: 19.10.2021 JP 2021171199
(71) Applicant: AJINOMOTO CO., INC., Chuo-ku Tokyo 104-8315 (JP)
(72) Inventor: TANAKA, Takayuki, Kawasaki-shi, Kanagawa 210-0801 (JP); HOMMA, Tatsuya, Kawasaki-shi, Kanagawa 210-0801 (JP)
(74) Representative: Mewburn Ellis LLP
(86) International application number: PCT/JP2022/037076
(87) International publication number: WO 2023/068032

(57) **Abstract**

A resin composition comprising (A) a magnetic powder and (B) a thermosetting resin, wherein an amount of (A) the magnetic powder relative to 100% by volume of nonvolatile components in the resin composition is 65% or more by volume, and (A) the magnetic powder comprises 10% or more by volume to 50% or less by volume of (A-1) a magnetic powder having a particle diameter of less than 1 µm.

## Description

### Technical Field

The present invention relates to a resin composition, a resin sheet, a circuit board, and a production method thereof, as well as an inductor part.

### Background Art

One method for producing a circuit board used in an electronic device is to fill a through hole in a substrate with a hole-filling agent such as a liquid resin paste, and then cure the filling agent. Magnetic paste as a resin paste containing magnetic powder was sometimes used as a hole-filling agent to fill the through hole in a circuit board for an inductor part (Patent Literature 1). Furthermore, the technology described in Patent Literature 2 was also known as a method for producing a circuit board.

### Citation List

### Patent Literature

Patent Literature 1: WO 2020/105704
Patent Literature 2: Japanese Patent Application Laid-open No. 2004-149758

### Summary of the Invention

### Technical Problem

The magnetic material as the material for the magnetic powder in the magnetic paste generally has a high specific gravity. Therefore, when the through hole is filled with the magnetic paste, part of the magnetic paste may cause liquid dripping and flow out of the through hole. Here, "liquid dripping" refers to the phenomenon in which a liquid material such as the magnetic paste drips due to its own weight.

In order to suppress the liquid dripping, the inventor considered increasing the amount of the magnetic powder contained in the magnetic paste to increase the thixotropy of the magnetic paste. However, as the thixotropy of the magnetic paste increases, the viscosity of the magnetic paste increases and the hole-filling property decreases, which may make it difficult to fill the through hole smoothly with the magnetic paste. Therefore, there were restrictions on the amount of the magnetic powder that the magnetic paste for through hole filling could contain; thus conventional magnetic pastes could not contain much amount of the magnetic powder. Therefore, it was difficult for the magnetic layer formed of the cured product of the magnetic paste in the through hole to have a high relative magnetic permeability.

Therefore, the inventor attempted to fill the through hole using a resin sheet having a resin composition layer formed of a resin composition containing the magnetic powder, instead of a liquid magnetic paste. In use, the resin sheet is laminated such that the resin composition layer bonds to the substrate with applying a pressure. Therefore, even when a large amount of the magnetic powder is contained in the resin composition, part of the resin composition layer can be easily filled into the through hole by the aforementioned pressure. Therefore, the magnetic layer can be smoothly formed in the through hole by the cured product of the resin composition. In addition, because the resin composition contained in the resin composition layer does not flow easily when no pressure is applied, the liquid dripping can be suppressed when using the resin sheet having that resin composition layer.

However, when the resin sheet is laminated with the substrate, the resin composition layer is usually formed not only in the through hole but also over a wide area on the surface of the substrate. Therefore, when that resin composition layer is cured, the magnetic layer may be formed over a wide area on the surface of the substrate. Therefore, polishing is generally performed to remove the unwanted magnetic layer. Specifically, after the resin composition layer is cured to form the magnetic layer, the magnetic layer is polished to remove the unwanted portions of the magnetic layer. The unwanted portions of the magnetic layer include, for example, portions outside of the through hole.

However, when the resin composition contained a large amount of the magnetic powder, the magnetic layer tends to be low in the polishing workability. Therefore, it may take a lot of time to polish the magnetic layer, and the polishing may cause damage to the magnetic layer, such as cracks and chips.

The present invention was conceived in view of the problems described above, and thus, an object thereof is to provide: a resin composition that can produce a cured product having a high polishing workability while containing much amount of magnetic powders; a resin sheet having a resin composition layer containing the resin composition; a circuit board having the magnetic layer containing the cured product of the resin composition, and a production method thereof; and an inductor part having the circuit board.

### Solution to Problem

The inventor of the present invention carried out an extensive investigation to solve the problems described above. As a result, the inventor found that, in a resin composition containing a particular range of amount of (A) a magnetic powder and (B) a thermosetting resin, when (A) the magnetic powder contains a particular range of amount of (A-1) a magnetic powder having a particle diameter of less than 1 µm, the aforementioned problems could be solved; and based on this finding, the present invention has been completed.

Namely, the present invention includes the following aspects.
[1] A resin composition comprising (A) a magnetic powder and (B) a thermosetting resin, wherein
   an amount of (A) the magnetic powder relative to 100% by volume of nonvolatile components in the resin composition is 65% or more by volume, and
   (A) the magnetic powder comprises 10% or more by volume to 50% or less by volume of (A-1) a magnetic powder having a particle diameter of less than 1 µm.
[2] The resin composition according to [1], wherein (B) the thermosetting resin comprises (B-1) an epoxy resin.
[3] The resin composition according to [1] or [2], wherein the resin composition comprises (C) a thermoplastic resin.
[4] The resin composition according to any one of [1] to [3], wherein the resin composition is for filling of a through hole.
[5] A resin sheet having a resin composition layer comprising the resin composition according to any one of [1] to [4] .
[6] The resin sheet according to [5], wherein the resin sheet comprises a support.
[7] A method for producing a circuit board, the method comprising steps of:
   laminating a substrate formed with a through hole and the resin sheet according to [5] or [6] to fill the through hole with a portion of the resin composition layer;
   curing the resin composition layer to form a magnetic layer; and
   polishing the magnetic layer, in this order.
[8] A circuit board comprising:
   a substrate formed with a through hole, and
   a magnetic layer filled in the through hole, wherein
   the magnetic layer comprises a cured product of the resin composition according to any one of [1] to [4].
[9] An inductor part comprising the circuit board according to [8].

### Advantageous Effects of Invention

According to the present invention, it is possible to provide: a resin composition that can produce a cured product having a high polishing workability while containing much amount of magnetic powders; a resin sheet having a resin composition layer containing the resin composition; a circuit board having the magnetic layer containing the cured product of the resin composition, and a production method thereof; and an inductor part having the circuit board.

### Brief Description of Drawings

FIG. 1 is a schematic cross sectional view illustrating a core substrate before forming a through hole in the production method of the circuit board according to one embodiment of the present invention.
FIG. 2 is a schematic cross sectional view illustrating the core substrate formed with the through hole in the production method of the circuit board according to one embodiment of the present invention.
FIG. 3 is a schematic cross sectional view illustrating the core substrate formed with a plated layer in the through hole in the production method of the circuit board according to one embodiment of the present invention.
FIG. 4 is a schematic cross sectional view illustrating the state of the lamination of the core substrate and the resin sheet in the production method of the circuit board according to one embodiment of the present invention.
FIG. 5 is a schematic cross sectional view illustrating the state of the lamination of the core substrate and the resin sheet in the production method of the circuit board according to one embodiment of the present invention.
FIG. 6 is a schematic cross sectional view to explain the step (2) in the production method of the circuit board according to one embodiment of the present invention.
FIG. 7 is a schematic cross sectional view to explain the step (3) in the production method of the circuit board according to one embodiment of the present invention.
FIG. 8 is a schematic cross sectional view to explain the step (5) in the production method of the circuit board according to one embodiment of the present invention.
FIG. 9 is a schematic cross sectional view to explain the step (5) in the production method of the circuit board according to one embodiment of the present invention.

### Description of Embodiments

The following is a detailed description of the present invention by showing embodiments and examples. The present invention is not limited to the embodiments and examples described below, so that the present invention may be carried out with any arbitrary modification so far as such modification is not outside the claims or the equivalent thereof.

In the explanation hereinafter, "resin component" in the resin composition means the components excluding inorganic particles such as magnetic powders from the nonvolatile components included in the resin composition, unless otherwise specifically mentioned.

### [1. Outline of the Resin Composition]

The resin composition according to one embodiment of the present invention contains a particular range of amount of (A) a magnetic powder and (B) a thermosetting resin. (A) The magnetic powder contains a particular range of amount of (A-1) a magnetic powder having a particle diameter of less than 1 um. In the following description, "(A-1) the magnetic powder having a particle diameter of less than 1 µm" may be referred to as "(A-1) the small diameter magnetic powder". This resin composition can produce a cured product having an improved polishing workability while the resin composition contains a large amount of (A) the magnetic powder.

The aforementioned resin composition may be used as the material for the resin composition layer of a resin sheet. In general, the resin sheet includes a resin composition layer comprising the resin composition. This resin sheet can be used to fill a through hole by laminating with a substrate having the through hole formed. Hereinafter, the "substrate formed with the through hole" may be referred to as the "core substrate". Specifically, when the core substrate and the resin sheet are laminated, a portion of the resin composition layer can enter into the through hole to fill the through hole. Unlike the liquid magnetic paste, the resin composition layer can suppress leakage from the through hole due to its own weight. Thus liquid dripping can be suppressed.

Because the resin composition contains a large amount of (A) the magnetic powder, the cured product obtained by curing the resin composition can have excellent magnetic properties. Therefore, the magnetic layer having excellent magnetic properties such as relative magnetic permeability and magnetic loss can be formed by the cured product of the resin composition.

Furthermore, the cured product of the resin composition can have an improved polishing workability. Therefore, the magnetic layer formed on the core substrate can be polished quickly and smoothly. Thus, for example, when the resin composition layer adheres to a wide surface area on the core substrate due to lamination of the core substrate and the resin sheet, and the resin composition layer is cured to form a magnetic layer, the magnetic layer formed over such a wide area can be removed in a short time by polishing. In addition, polishing can be performed while suppressing the damages such as cracking and chipping, so the polished surface of the magnetic layer can be made consistently smooth. Here, "polished surface" means a surface that has received a polishing treatment.

With regard to the mechanism how such an improved polishing workability can be achieved, the inventor of the present invention presumes as follows. That is, because (A) the magnetic powder generally has a high rigidity, the particles of (A) the magnetic powder are difficult to be scraped by polishing. Therefore, during polishing, some or all of particles of (A) the magnetic powder are dislodged from the cured product of the resin composition, so that polishing of the cured product may progress. At this time, when (A) the magnetic powder contains (A-1) the small diameter magnetic powder, particles of (A-1) the small diameter magnetic powder can be dislodged from the cured product by a smaller force than particles having a larger diameter. Therefore, the inclusion of (A-1) the small diameter magnetic powder can speed up the progress of polishing of the cured product. In addition, when the speed of progress of polishing can be accelerated as described above, the load applied to the resin component can be reduced, so that the damage to the resin component due to polishing can be suppressed. Furthermore, when the resin composition described above includes an appropriate range of amount of (A-1) the small diameter magnetic powder, the excessive occurrence of (A-1) the small diameter magnetic powder dislodging from the cured product can be suppressed. Therefore, the damages such as chipping and cracking of the cured product can be suppressed. Therefore, the cured product of the resin composition described above can be efficiently polished while suppressing breakage, and thus this can have an excellent polishing workability.

### [2. (A) Magnetic Powder]

The resin composition according to one embodiment of the present invention includes (A) the magnetic powder as a component (A). As for (A) the magnetic powder, particles of the material having a relative magnetic permeability greater than 1 may be used. In general, the material of (A) the magnetic powder is an inorganic material, and may be any of a soft magnetic material and a hard magnetic material. The material of (A) the magnetic powder may be used singly or as a combination of two or more of them. Therefore, (A) the magnetic powder may be any of a soft magnetic powder, a hard magnetic powder, and a combination of the soft magnetic powder and the hard magnetic powder. (A) The magnetic powder may be used singly or as a combination of two or more of them. In particular, from the viewpoint of effectively obtainning the effects of the present invention, (A) the magnetic powder preferably contains a soft magnetic powder, and more preferably contains only the soft magnetic powder.

Illustrative examples of (A) the magnetic powder may include a magnetic metal oxide powder and a magnetic metal powder.

Illustrative examples of the magnetic metal oxide powder may include ferrite powders such as a Fe-Mn type ferrite powder, a Fe-Mn-Mg type ferrite powder, a Fe-Mn-Mg-Sr type ferrite powder, a Fe-Mg-Zn type ferrite powder, a Fe-Mg-Sr type ferrite powder, a Fe-Zn-Mn type ferrite powder, a Fe-Cu-Zn type ferrite powder, a Fe-Ni-Zn type ferrite powder, a Fe-Ni-Zn-Cu type ferrite powder, a Fe-Ba-Zn type ferrite powder, a Fe-Ba-Mg type ferrite powder, a Fe-Ba-Ni type ferrite powder, a Fe-Ba-Co type ferrite powder, a Fe-Ba-Ni-Co type ferrite powder, and a Fe-Y type ferrite powder; and iron oxide powders such as an iron (III) oxide powder and a tri-iron tetroxide powder. Among these, ferrite powders are preferable. Usually, the ferrite powders are composed of composite oxides including iron oxides as main components, and are chemically stable. Therefore, the ferrite powders offer advantages such as a high corrosion resistance, a low risk of ignition, and a resistance to demagnetization. Among them, ferrite powders containing at least one element selected from the group consisting of Mn and Zn is preferable, and ferrite powder containing Mn is more preferable, and a Fe-Mn type ferrite powder and a Fe-Zn-Mn type ferrite powder are particularly preferable. The Fe-Mn type ferrite powder represents the ferrite powder containing Fe and Mn, and the Fe-Zn-Mn type ferrite powder represents the ferrite powder containing Fe, Zn, and Mn.

Illustrative examples of the magnetic metal powder may include a pure iron powder; and crystalline or non-crystalline alloy powders such as a Fe-Si type alloy powder, a Fe-Si-Al type alloy powder, a Fe-Cr type alloy powder, a Fe-Cr-Si type alloy powder, a Fe-Ni-Cr type alloy powder, a Fe-Cr-Al type alloy powder, a Fe-Ni type alloy powder, a Fe-Ni-Si type alloy powder, a Fe-Ni-B type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder. Among them, the alloy powders are preferable, and the iron alloy type powders are more preferable. As for the iron alloy type powder, the iron alloy type powder containing Fe, as well as at least one element selected from the group consisting of Si, Cr, and Ni is preferable, and the Fe-Cr-Si type alloy powder and the Fe-Ni type alloy powder are especially preferable. The Fe-Cr-Si type alloy powder represents the alloy powder containing Fe, Cr, and Si; and the Fe-Ni type alloy powder represents the alloy powder containing Fe and Ni.

The amount (% by volume) of (A) the magnetic powder included in the resin composition relative to 100% by volume of the nonvolatile components in the resin composition is usually 65% or more by volume, preferably 67% or more by volume, and especially preferably 70% or more by volume. When the resin composition contains (A) the magnetic powder in the amount of the aforementioned range, the magnetic properties of the cured product of the resin composition can be improved. In general, a resin composition containing a large amount of the magnetic powder as described above is inferior in filling the through hole by the printing method. However, according to the method of laminating the resin sheet including the resin composition layer containing the resin composition onto the core substrate having the through hole, the through hole can be filled smoothly by the resin composition. Furthermore, in general, a cured product of the resin composition containing a large amount of the magnetic powder as described above tends to have a poor polishing workability; but according to the resin composition according to the present embodiment, the polishing workability of the cured product of the resin composition can be improved. Although there is no particular restriction in the upper limit of the amount of (A) the magnetic powder, from the viewpoint of particularly good filling into the through hole and polishing workability of the cured product of the resin composition, it is preferably 95% or less by volume, more preferably 90% or less by volume, and especially preferably 85% or less by volume.

The volume content (% by volume) of each component in the resin composition can be determined by calculation from the mass of the component in the resin composition. Specifically, the volume of each component is obtained by dividing the mass with the specific gravity; and the volume content (% by volume) can be calculated from the volume of each component obtained.

(A) The magnetic powder contains a particular range of amount of (A-1) the small diameter magnetic powder having a particle diameter of less than 1 um. Specifically, the amount (% by volume) of (A-1) the small diameter magnetic powder is usually 10% or more by volume, preferably 13% or more by volume, and especially preferably 16% or more by volume, and is preferably 50% or less by volume, more preferably 47% or less by volume, and especially preferably 44% or less by volume, relative to 100% by volume of the total amount of (A) the magnetic powder. When the amount of (A-1) the small diameter magnetic powder contained in (A) the magnetic powder is in the aforementioned range, the cured product of the resin composition can have an excellent polishing workability.

The amount of (A-1) the small diameter magnetic powder included in (A) the magnetic powder may be measured with a laser diffraction scattering method based on the Mie scattering theory. Specifically, the particle diameter distribution of (A) the magnetic powder is prepared on a volume basis with a laser diffraction scattering type particle diameter distribution analyzer; and from the particle diameter distribution thereby obtained, the amount of (A-1) the small diameter magnetic powder having a particle diameter of less than 1 um can be measured. The powders that are dispersed in water by means of an ultrasonic wave can be suitably used as the measurement sample. Illustrative examples of the laser diffraction scattering type particle diameter distribution analyzer may include "LA-500" manufactured by Horiba Ltd. and "SALD-2200" manufactured by Shimadzu Corp.

(A) The magnetic powder containing a particular range of amount of (A-1) the small diameter magnetic powder as described above can be produced, for example, by mixing several types of magnetic powders having appropriate particle diameter distributions. In a specific example, (A) the magnetic powder can be obtained by mixing a first magnetic powder having an average particle diameter of less than 1 um and a second magnetic powder having an average particle diameter of 1 um or more in an appropriate quantity ratio. However, each of the magnetic powders such as the first magnetic powder and the second magnetic powder may include particles having particle diameters of less than 1 um and particles having particle diameters of 1 um or more. Therefore, the amount of the first magnetic powder is generally not equal to the amount of (A-1) the small diameter magnetic powder. Therefore, in order to obtain (A) the magnetic powder containing a particular range of amount of (A-1) the small diameter magnetic powder, the quantity ratio of the first magnetic powder and the second magnetic powder is usually required to set based on the particle diameter distributions of the first magnetic powder and the second magnetic powder, after determining each of their particle diameter distributions.

(A) The magnetic powder includes (A-2) a magnetic powder having a particle diameter of 1 um or more in combination with (A-1) the small diameter magnetic powder. In the following description, "(A-2) the magnetic powder having a particle diameter of 1 um or more" may be referred to as "(A-2) the large diameter magnetic powder". (A) The magnetic powder may have an average particle diameter of 1 um or more because it contains (A-2) the large diameter magnetic powder the amount of which is the same as or more than that of (A-1) the small diameter magnetic powder on a volume basis. The average particle diameter of (A) the magnetic powder is preferably 1 um or more, more preferably 1.4 um or more, especially preferably 1.6 um or more, and is preferably 10 um or less, more preferably 7.5 um or less, and especially preferably 5.0 m or less.

The average particle diameter is the median diameter on a volume basis, unless otherwise specifically mentioned. The average particle diameter can be measured with a laser diffraction scattering method based on the Mie scattering theory. Specifically, the particle diameter distribution thereof is prepared on a volume basis by using a laser diffraction scattering type particle diameter distribution analyzer, in which the median diameter thereof can be measured as the average particle diameter. The powders that are dispersed in water by means of an ultrasonic wave can be suitably used as the measurement sample. Illustrative examples of the laser diffraction scattering type particle diameter distribution analyzer may include "LA-500" manufactured by Horiba Ltd. and "SALD-2200" manufactured by Shimadzu Corp.

From the viewpoint of obtaining a higher relative magnetic permeability, the specific surface area of the (A) the magnetic powder is preferably 0.05 m²/g or more, more preferably 0.1 m²/g or more, and still more preferably 0.3 m²/g or more, and is preferably 10 m²/g or less, more preferably 8 m²/g or less, and still more preferably 5 m²/g or less. The specific surface area of (A) the magnetic powder can be measured by the BET method. Specifically, the BET specific surface area can be measured according to the BET method by adsorbing a nitrogen gas onto the sample surface using a specific surface area measurement instrument ("Macsorb HM Model 1210" manufactured by Mountech Co., Ltd.) with the BET multipoint method.

The particles of (A) the magnetic powder are preferably spherical particles or ellipsoidal particles. The ratio (aspect ratio) of the length of the longitude axis to the length of the short axis of the particles of (A) the magnetic powder is preferably 2 or less, more preferably 1.5 or less, and still more preferably 1.2 or less, and is usually 1.0 or more. In general, when the particle shape of the magnetic powder is not a spherial shape but a flat shape, a relative magnetic permeability tends to be increased. On the other hand, when the particle shape of the magnetic powder is close to a spherical shape, the magnetic loss tends to be decreased.

The true specific gravity of (A) the magnetic powder may be, for example, in the range of 4 g/cm³ to 10 g/cm³.

The amount (% by mass) of the (A) the magnetic powder included in the resin composition is preferably 75% or more by mass, more preferably 80% or more by mass, and especially preferably 85% or more by mass, and is preferably 99% or less by mass, more preferably 98% or less by mass, and especially preferably 96% or less by mass, relative to 100% by mass of the nonvolatile components in the resin composition. When the amount of (A) the magnetic powder is within the aforementioned range, the cured product of the resin composition can have good magnetic properties and especially improved polishing workability.

The amount (% by mass) of (A-1) the small diameter magnetic powder is preferably 8% or more by mass, more preferably 10% or more by mass, and especially preferably 12% or more by mass, and is preferably 50% or less by mass, more preferably 45% or less by mass, and especially preferably 40% or less by mass, relative to 100% by mass of the total amount of (A) the magnetic powder. When the amount of (A-1) the small diameter magnetic powder contained in (A) the magnetic powder is in the aforementioned range, the cured product of the resin composition can have good magnetic properties and especially improved polishing workability.

### [3. (B) Thermosetting Resin]

The resin composition according to one embodiment of the present invention includes (B) the thermosetting resin as a component (B). (B) The thermosetting resin can usually bind (A) the magnetic powder. In addition, (B) the thermosetting resin can usually react by heat to form a bond and cure the resin composition. Thus, the resin composition containing a combination of (A) the magnetic powder and (B) the thermosetting resin can be cured to form a magnetic layer.

Illustrative examples of (B) the thermosetting resin may include an epoxy resin, a phenol type resin, an active ester type resin, an amine type resin, an acid anhydride type resin, a benzoxazine type resin, a cyanate ester type resin, and a carbodiimide type resin. (B) The thermosetting resin may be used singly or as a combination of two or more of these resins.

It is preferable that (B) the thermosetting resin contains (B-1) an epoxy resin. (B-1) The epoxy resin represents the resin having one or more epoxy groups in its molecule. When (B) the thermosetting resin contains (B-1) the epoxy resin, filling property into the through hole and the magnetic properties and the polishing workability of the cured product of the resin composition can be particularly improved.

Illustrative examples of (B-1) the epoxy resin may include a bixylenol type epoxy resin, a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenolic novolac type epoxy resin; a glycidylamine type epoxy resin; a glycidyl ester type epoxy resin; a cresol novolac type epoxy resin; a biphenyl type epoxy resin; a linear aliphatic epoxy resin; an epoxy resin containing a butadiene structure; an alicyclic epoxy resin; an alicyclic epoxy resin containing an ester skeleton; a heterocyclic epoxy resin; an epoxy resin containing a spiro ring; a cyclohexane type epoxy resin; a cyclohexane dimethanol type epoxy resin; a trimethylol type epoxy resin; a tetraphenylethane type epoxy resin; epoxy resins containing a fused ring skeleton such as a naphthylene ether type epoxy resin, a tert-butyl-catechol type epoxy resin, a naphthalene type epoxy resin, a naphthol type epoxy resin, an anthracene type epoxy resin, and a naphthol novolac type epoxy resin; an isocyanurate type epoxy resin; an epoxy resin containing an alkyleneoxy skeleton and a butadiene skeleton; and an epoxy resin containing a fluorene structure. (B-1) The epoxy resins may be used singly or as a combination of two or more of them.

It is preferable that (B-1) the epoxy resin includes an epoxy resin having two or more epoxy groups in one molecule. The ratio of the epoxy resin having two or more epoxy groups in one molecule is preferably 50% or more by mass, more preferably 60% or more by mass, and especially preferably 70% or more by mass, relative to 100% by mass of the total amount of (B-1) the epoxy resin.

It is preferable that (B-1) the epoxy resin includes an aromatic structure. When two or more epoxy resins are used, it is preferable that one or more of the epoxy resins include the aromatic structure. The aromatic structure is the chemical structure that is generally defined as aromatic, including a polycyclic aromatic ring and an aromatic heterocycle.

In (B-1) the epoxy resin, there are an epoxy resin that is in the state of liquid at 20°C (hereinafter, this may be called "liquid epoxy resin") and an epoxy resin that is in the state of solid at 20°C (hereinafter, this may be called "solid epoxy resin"). (B-1) The epoxy resin may be only the liquid epoxy resin, or only the solid epoxy resin, or a combination of the liquid epoxy resin and the solid epoxy resin. Among them, (B-1) the epoxy resin preferably contains the liquid epoxy resin, especially preferably contains only the liquid epoxy resin.

As for the liquid epoxy resin, the liquid epoxy resin having two or more epoxy groups in one molecule thereof is preferable. The liquid epoxy resin is preferably a bisphenol A type epoxy resin, a bisphenol F type epoxy resin, a bisphenol AF type epoxy resin, a naphthalene type epoxy resin, a glycidyl ester type epoxy resin, a glycidylamine type epoxy resin, a phenol novolac type epoxy resin, an alicyclic epoxy resin containing an ester skeleton, a cyclohexane type epoxy resin, a cyclohexane dimethanol type epoxy resin, an epoxy resin containing a butadiene structure, an epoxy resin containing an alkyleneoxy skeleton and a butadiene skeleton, an epoxy resin containing a fluorene structure, and a dicyclopentadiene type epoxy resin. Among them, the bisphenol A type epoxy resin, the bisphenol F type epoxy resin, the naphthalene type epoxy resin, the glycidylamine type epoxy resin, and the alicyclic epoxy resin containing an ester skeleton are particularly preferable.

Specifically, illustrative examples of the liquid epoxy resin may include "YX7400" manufactured by Mitsubishi Chemical Corp.; "HP4032", "HP4032D", and "HP4032SS" manufactured by DIC Corp. (these are naphthalene type epoxy resins); "828US", "828EL", "jER828EL", "825", and "Epikote 828EL" manufactured by Mitsubishi Chemical Corp. (these are bisphenol A type epoxy resins); "jER807" and "1750" manufactured by Mitsubishi Chemical Corp. (both are bisphenol F type epoxy resins); "jER152" manufactured by Mitsubishi Chemical Corp. (a phenol novolac type epoxy resin); "630", "630LSD", and "604" manufactured by Mitsubishi Chemical Corp. (these are glycidyl amine type epoxy resins); "ED-523T" manufactured by Adeka Corp. (a glycyrol type epoxy resin); "EP-3950L" and "EP-3980S" manufactured by Adeka Corp. (both are glycidylamine type epoxy resins); "EP-4088S" manufactured by Adeka Corp. (a dicyclopentadiene type epoxy resin); "ZX1059" manufactured by Nippon Steel Chemical & Material Co., Ltd. (a mixture of a bisphenol A type epoxy resin and a bisphenol F type epoxy resin); "EX-721" manufactured by Nagase ChemteX Corp. (a glycidyl ester type epoxy resin); "EX-991L" manufactured by Nagase ChemteX Corp. (an epoxy resin containing an alkyleneoxy skeleton); "Celloxide 2021P" and "Celloxide 2081" manufactured by Daicel Corp. (alicyclic epoxy resins containing an ester skeleton); "PB-3600" manufactured by Daicel Corp., "JP-100" and "JP-200" manufactured by Nippon Soda Co., Ltd. (epoxy resins containing a butadiene skeleton); "ZX1658" and "ZX1658GS" manufactured by Nippon Steel Chemical & Material Co., Ltd. (liquid 1,4-glycidylcyclohexane type epoxy resins); and "EG-280" manufactured by Osaka Gas Chemicals Co (an epoxy resin containing a fluorene structure). These liquid epoxy resins may be used singly or as a combination of two or more of them.

As for the solid epoxy resin, the solid epoxy resin having three or more epoxy groups in one molecule thereof is preferable, while the aromatic solid epoxy resin having three or more epoxy groups in one molecule thereof is more preferable. The solid epoxy resin is preferably a bixylenol type epoxy resin, a naphthalene type epoxy resin, a naphthalene type four-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, or a tetraphenylethane type epoxy resin; among these, the dicyclopentadiene type epoxy resin is especially preferable.

Specifically, illustrative examples of the solid epoxy resin may include "HP4032H" (a naphthalene type epoxy resin) manufactured by DIC Corp.; "HP-4700" and "HP-4710" (naphthalene type four-functional epoxy resins) manufactured by DIC Corp.; "N-690" (a cresol novolac type epoxy resin) manufactured by DIC Corp.; "N-695" (a cresol novolac type epoxy resin) manufactured by DIC Corp.; "HP-7200", "HP-7200HH", and "HP-7200H" (dicyclopentadiene type epoxy resins) manufactured by DIC Corp.; "EXA-7311", "EXA-7311-G3", "EXA-7311-G4", "EXA-7311-G4S", and "HP6000" (naphthylene ether type epoxy resins) manufactured by DIC Corp.; "EPPN-502H" (a trisphenol type epoxy resin) manufactured by Nippon Kayaku Co., Ltd.; "NC7000L" (a naphthol novolac type epoxy resin) manufactured by Nippon Kayaku Co., Ltd.; "NC3000H", "NC3000", "NC3000L", and "NC3100" (biphenyl type epoxy resins) manufactured by Nippon Kayaku Co., Ltd.; "ESN475V" (a naphthalene type epoxy resin) manufactured by Nippon Steel Chemical & Material Co., Ltd.; "ESN485" (a naphthol novolac type epoxy resin) manufactured by Nippon Steel Chemical & Material Co., Ltd.; "YX4000H", "YX4000", and "YL6121" (biphenyl type epoxy resins) manufactured by Mitsubishi Chemical Corp.; "YX4000HK" (a bixylenol type epoxy resin) manufactured by Mitsubishi Chemical Corp.; "YX8800" (an anthracene type epoxy resin) manufactured by Mitsubishi Chemical Corp.; "YX7700" (a novolac type epoxy resin containing a xylene structure) manufactured by Mitsubishi Chemical Corp.; "PG-100" and "CG-500" manufactured by Osaka Gas Chemicals Co., Ltd.; "YL7760" (a bisphenol AF type type epoxy resin) manufactured by Mitsubishi Chemical Corp.; "YL7800" (a fluorene type epoxy resin) manufactured by Mitsubishi Chemical Corp.; "jER1010" (a solid bisphenol A type epoxy resin) manufactured by Mitsubishi Chemical Corp.; and "jER1031S" (a tetraphenylethane type epoxy resin) manufactured by Mitsubishi Chemical Corp. These solid epoxy resins may be used singly or as a combination of two or more of them.

When the epoxy resin is used as a combination of the liquid epoxy resin and the solid epoxy resin, the mass ratio of the liquid epoxy resin to the solid epoxy resin (liquid epoxy resin/solid epoxy resin) is preferably 0.5 or more, more preferably 1 or more, still more preferably 5 or more, and especially preferably 10 or more.

The epoxy equivalent of (B-1) the epoxy resin is preferably 50 g/eq. to 5000 g/eq., more preferably 50 g/eq. to 3000 g/eq., still more preferably 80 g/eq. to 2000 g/eq., and far still more preferably 110 g/eq. to 1000 g/eq. The epoxy equivalent is the mass of the resin per one equivalent of the epoxy group. The epoxy equivalent can be measured in accordance with JIS K7236.

The weight-average molecular weight (Mw) of (B-1) the epoxy resin is preferably 100 to 5000, more preferably 250 to 3000, and still more preferably 400 to 1500. The weight-average molecular weight of the resin can be measured in terms of polystyrene by a gel permeation chromatography (GPC) method.

The amount (% by mass) of (B-1) the epoxy resin included in the resin composition is preferably 0.1% or more by mass, more preferably 0.5% or more by mass, and especially preferably 1% or more by mass, and is preferably 15% or less by mass, more preferably 10% or less by mass, and especially preferably 5% or less by mass, relative to 100% by mass of the nonvolatile components in the resin composition. When the amount of (B-1) the epoxy resin is in the aforementioned range, the magnetic properties and the polishing workability of the cured product of the resin composition can be particularly improved.

The amount (% by mass) of (B-1) the epoxy resin included in the resin composition is preferably 10% or more by mass, more preferably 20% or more by mass, and especially preferably 30% or more by mass, and is preferably 80% or less by mass, more preferably 70% or less by mass, and especially preferably 60% or less by mass, relative to 100% by mass of the resin components in the resin composition. When the amount of (B-1) the epoxy resin is in the aforementioned range, the magnetic properties and the polishing workability of the cured product of the resin composition can be particularly improved.

The mass ratio M(B-1)/M(A-1) between the mass M(A-1) of (A-1) the small diameter magnetic powder and the mass M(B-1) of (B-1) the epoxy resin included in the resin composition is preferably within a particular range. Specifically, the range of the mass ratio M(B-1)/M(A-1) is preferably 0.07 or more, and more preferably 0.08 or more, and is preferably 0.35 or less, more preferably 0.32 or less, and especially preferably 0.30 or less. When the mass ratio M(B-1)/M(A-1) is in the aforementioned range, the magnetic properties and the polishing workability of the cured product of the resin composition can be particularly improved.

The volume ratio V(B-1)/V(A-1) between the volume V(A-1) of (A-1) the small diameter magnetic powder and the volume V(B-1) of (B-1) the epoxy resin included in the resin composition is preferably in a particular range. Specifically, the range of the volume ratio V(B-1)/V(A-1) is preferably 0.30 or more, more preferably 0.32 or more, and especially preferably 0.35 or more, and is preferably 1.5 or less, more preferably 1.4 or less, and especially preferably 1.3 or less. When the volume ratio V(B-1)/V(A-1) is in the aforementioned range, the magnetic properties and the polishing workability of the cured product of the resin composition can be particularly improved.

When (B) the thermosetting resin contains (B-1) the epoxy resin, (B) the thermosetting resin preferably contains a resin that can react with (B-1) the epoxy resin to form a bond. Hereinafter, the resin that can react with (B-1) the epoxy resin to form a bond may be referred to as "(B-2) a curing agent". Illustrative examples of (B-2) the curing agent may include a phenol type resin, an active ester type resin, an amine type resin, a carbodiimide type resin, an acid anhydride type resin, a benzoxazine type resin, a cyanate ester type resin, and a thiol type resin. (B-2) The curing agent may be used singly or as a combination of two or more of them. Among them, the phenol type resin is preferable from the viewpoint of the magnetic properties and the polishing workability of the cured product of the resin composition.

As for the phenol type resin, a resin having one or more, preferably two or more, hydroxyl groups bonding to an aromatic ring such as a benzene ring or a naphthalene ring in one molecule may be used. In view of the heat resistance and the water resistance, the phenol type resin containing a novolac structure is preferable. In view of the adhesion property, a nitrogen-containing phenol type resin is preferable, and a phenol type resin containing a triazine skeleton is more preferable. In particular, from the viewpoint of highly satisfying a heat resistance, a water resistance, and an adhesion property, the phenol novolac resin containing a triazine skeleton is preferable.

Specific examples of the phenol type resin may include "MEH-7700", "MEH-7810", "MEH-7851", and "MEH-8000H", all being manufactured by Meiwa Plastic Industries, Ltd.; "NHN", "CBN", and "GPH", all being manufactured by Nippon Kayaku Co., Ltd.; "SN-170", "SN-180", "SN-190", "SN-475", "SN-485", "SN-495", "SN-495V", "SN-375", and "SN-395", all being manufactured by Nippon Steel Chemical & Material Co., Ltd.; "TD-2090", "TD-2090-60M", "LA-7052", "LA-7054", "LA-1356", "LA-3018", "LA-3018-50P", "EXB-9500", "HPC-9500", "KA-1160", "KA-1163", and "KA-1165", all being manufactured by DIC Corp.; and "GDP-6115L", "GDP-6115H", and "ELPC75", all being manufactured by Gunei Chemical Industry Co., Ltd.

As for the active ester type resin, a compound having one or more, and preferably two or more active ester groups in one molecule thereof may be used. Among the active ester type resin, the compound having two or more highly reactive ester groups in one molecule thereof are preferable as the active ester type resin, such as a phenol ester type compound, a thiophenol ester type compound, an N-hydroxyamine ester type compound, and an ester compound of a heterocyclic hydroxy compound. The active ester type resin is preferably the compound that is obtained by condensation reaction of a carboxylic acid compound and/or a thiocarboxylic acid compound with a hydroxy compound and/or a thiol compound. Especially, from the viewpoint of enhancement of a heat resistance, an active ester type resin obtained from a carboxylic acid compound and a hydroxy compound is preferable, while an active ester type resin obtained from a carboxylic acid compound and a phenol compound and/or a naphthol compound is more preferable. Illustrative examples of the carboxylic acid compound may include benzoic acid, acetic acid, succinic acid, maleic acid, itaconic acid, phthalic acid, isophthalic acid, terephthalic acid, and pyromellitic acid. Illustrative examples of the phenol compound or the naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolac. Here, the "dicyclopentadiene type diphenol compound" means a diphenol compound obtained by condensation of one dicyclopentadiene molecule with two phenol molecules.

Specific examples of the preferable active ester type resin may include an active ester type resin containing a dicyclopentadiene type diphenol structure, an active ester type resin containing a naphthalene structure, an active ester type resin containing an acetylated phenol novolac, and an active ester type resin containing a benzoylated phenol novolac. Among them, the active ester type resin containing a naphthalene structure and the active ester type resin containing a dicyclopentadiene type diphenol structure are more preferable. Here, the "dicyclopentadiene type diphenol structure" means the divalent structure unit formed of phenylene-dicyclopentylene-phenylene.

Illustrative examples of the commercially available active ester type resin may include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (all are manufactured by DIC Corp.); active ester type resins containing a naphthalene structure, such as "EXB-9416-70BK", "EXB-8150-65T", "EXB-8100L-65T", and "EXB-8150L-65T" (all are manufactured by DIC Corp.); active ester type resins containing an acetylated phenol novolac, such as "DC808" (manufactured by Mitsubishi Chemical Corp.); active ester type resins containing a benzoylated phenol novolac, such as "YLH1026" (manufactured by Mitsubishi Chemical Corp.); active ester type resins as an acetylated phenol novolac, such as "DC808" (manufactured by Mitsubishi Chemical Corp.); and active ester type resins as a benzoylated phenol novolac, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

As for the amine type resin, a resin having one or more, and preferably two or more amino groups in one molecule may be used. Illustrative examples of the amine type resin may include an aliphatic amine compound, a polyether amine compound, an alicyclic amine compound, and an aromatic amine compound. Among them, an aromatic amine compound is preferable. The amine type resin is preferably a primary amine and a secondary amine; a primary amine is more preferable. Specific examples of the amine type resin may include 4,4'-methylenebis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylenediamine, m-xylylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof may include "KAYABOND C-200S", "KAYABOND C-100", "KAYAHARD A-A", "KAYAHARD A-B", and "KAYAHARD A-S", all being manufactured by Nippon Kayaku Co. Ltd., as well as "Epicure W" manufactured by Mitsubishi Chemical Corp.

As for the carbodiimide type resin, a resin having one or more, and preferably two or more carbodiimide structures in one molecule may be used. Specific examples of the carbodiimide type resin may include biscarbodiimides including aliphatic biscarbodiimides such as tetramethylene-bis(t-butylcarbodiimide) and cyclohexane-bis(methylene-t-butylcarbodiimide), and aromatic biscarbodiimides such as phenylene-bis(xylylcarbodiimide); and polycarbodiimides including aliphatic polycarbodiimides such as polyhexamethylene carbodiimide, polytrimethylhexamethylene carbodiimide, polycyclohexylene carbodiimide, poly(methylenebiscyclohexylene carbodiimide), and poly(isophorone carbodiimide), and aromatic polycarbodiimides such as poly(phenylene carbodiimide), poly(naphthylene carbodiimide), poly(tolylene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylylene carbodiimide), poly(tetramethylxylylene carbodiimide), poly(methylenediphenylene carbodiimide), and poly[methylenebis(methylphenylene) carbodiimide]. Illustrative examples of the commercially available carbodiimide type resin may include "Carbodilite V-02B", "Carbodilite V-03", "Carbodilite V-04K", "Carbodilite V-07", and "Carbodilite V-09", which are all manufactured by Nisshinbo Chemical Inc.; and "Stabaxol P", "Stabaxol P400", and "Hycasyl 510", which are all manufactured by Rhein Chemie GmbH.

As for the acid anhydride type resin, a resin that has one or more acid anhydride groups in one molecule may be used, in which the resin having two or more acid anhydride groups in one molecule is preferable. Specific examples of the acid anhydride type resin may include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid. Illustrative examples of the commercially available product of the acid anhydride type resin may include "HNA-100", "MH-700", "MTA-15", "DDSA", and "OSA", which are all manufactured by New Japan Chemical Co., Ltd.; "YH-306" and "YH-307", which are both manufactured by Mitsubishi Chemical Corp.; "HN-2200" and "HN-5500", which are both manufactured by Hitachi Chemical Co., Ltd.; and "EF-30", "EF-40, "EF-60", and "EF-80", which are all manufactured by Cray Valley S.A.

Specific examples of the benzoxazine type resin may include "JBZ-OD100", "JBZ-OP100D", and "ODA-BOZ", which are all manufactured by JFE Chemical Corp.; "P-d" and "F-a", which are manufactured by Shikoku Chemicals Corp.; and "HFB2006M" manufactured by Showa Highpolymer Co., Ltd.

Illustrative examples of the cyanate ester type resin may include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene)(benzene, bis(4-cyanatephenyl) thioether, and bis(4-cyanatephenyl) ether; polyfunctional cyanate resins derived from a phenol novolac, a cresol novolac, and the like; and a prepolymer in which these cyanate resins partially form triazine. Specific examples of the cyanate ester type resin may include "PT30" and "PT60" (both are phenol novolac type polyfunctional cyanate ester resins); "ULL-950S" (a polyfunctional cyanate ester); "BA230" and "BA230S75" (prepolymers in which part or all of bisphenol A dicyanate form triazine so as to be a trimer), all of these being manufactured by Lonza Japan Ltd.

Illustrative examples of the thiol type resin may include trimethylolpropane tris(3-mercaptopropionate), pentaerythritol tetrakis(3-mercaptobutyrate), and tris(3-mercaptopropyl) isocyanurate.

The active group equivalent of (B-2) the curing agent is preferably 50 g/eq. to 3000 g/eq., more preferably 100 g/eq. to 1000 g/eq., still more preferably 100 g/eq. to 500 g/eq., and especially preferably 100 g/eq. to 300 g/eq. The active group equivalent is the mass of (B-2) the curing agent per one equivalent of the active group.

The number of the active groups in (B-2) the curing agent relative to one epoxy group in (B-1) the epoxy resin is preferably 0.01 or more, more preferably 0.1 or more, and especially preferably 0.5 or more, and is preferably 10 or less, more preferably 5 or less, and especially preferably 3 or less. The active group in (B-2) the curing agent is, for example, an active hydroxy group and the like; they are different depending on kinds of the curing agent. The number of the epoxy groups in (B-1) the epoxy resin is the total value obtained by dividing the mass of the solid portions in each epoxy resin with the epoxy equivalent and adding the divided values for all the epoxy resins. The number of the active groups in (B-2) the curing agent is the total value obtained by dividing the mass of the solid portions in each curing agent with the active group equivalent and adding the divided values for all the curing agents.

The amount of (B-2) the curing agent included in the resin composition is preferably 0.1% or more by mass, more preferably 0.5% or more by mass, and especially preferably 1% or more by mass, and is preferably 15% or less by mass, more preferably 10% or less by mass, and especially preferably 5% or less by mass, relative to 100% by mass of the nonvolatile components in the resin composition. When the amount of (B-2) the curing agent is in the aforementioned range, the magnetic properties and the polishing workability of the cured product of the resin composition can be particularly improved.

The amount (% by mass) of (B-2) the curing agent included in the resin composition is preferably 10% or more by mass, more preferably 20% or more by mass, and especially preferably 30% or more by mass, and is preferably 70% or less by mass, more preferably 60% or less by mass, and especially preferably 50% or less by mass, relative to 100% by mass of the resin components in the resin composition. When the amount of (B-2) the curing agent is in the aforementioned range, the magnetic properties and the polishing workability of the cured product of the resin composition can be particularly improved.

The weight-average molecular weight (Mw) of (B) the thermosetting resin may be in the same range as that of the weight-average molecular weight of (B-1) the epoxy resin.

The amount (% by mass) of the (B) the thermosetting resin included in the resin composition is preferably 0.1% or more by mass, more preferably 1% or more by mass, and especially preferably 2% or more by mass, and is preferably 15% or less by mass, more preferably 13% or less by mass, and especially preferably 10% or less by mass, relative to 100% by mass of the nonvolatile components in the resin composition. When the amount of (B) the thermosetting resin is in the aforementioned range, the magnetic properties and the polishing workability of the cured product of the resin composition can be particularly improved.

The amount (% by volume) of (B) the thermosetting resin included in the resin composition is preferably 5% or more by volume, more preferably 9% or more by volume, and especially preferably 14% or more by volume, and is preferably 35% or less by volume, more preferably 30% or less by volume, and especially preferably 25% or less by volume, relative to 100% by volume of the nonvolatile components in the resin composition. When the amount of (B) the thermosetting resin is in the aforementioned range, the magnetic properties and the polishing workability of the cured product of the resin composition can be particularly improved.

The amount (% by mass) of the (B) the thermosetting resin included in the resin composition is preferably 50% or more by mass, more preferably 60% or more by mass, and especially preferably 70% or more by mass, and is preferably 95% or less by mass, more preferably 90% or less by mass, and especially preferably 85% or less by mass, relative to 100% by mass of the resin components in the resin composition. When the amount of (B) the thermosetting resin is in the aforementioned range, the magnetic properties and the polishing workability of the cured product of the resin composition can be particularly improved.

### [4. (C) Thermoplastic Resin]

The resin composition according to one embodiment of the present invention may further include (C) a thermoplastic resin as an optional component in combination with the components (A) and (B) described above. (C) The thermoplastic resin as a component (C) does not include those that fall under the components (A) and (B) described above. (C) The thermoplastic resin can effectively improve the mechanical properties of the cured product of the resin composition.

Illustrative examples of (C) the thermoplastic resin may include a phenoxy resin, a polyimide resin, a polyvinyl acetal resin, a polyolefin resin, a polybutadiene resin, a polyamide imide resin, a polyether imide resin, a polysulfone resin, a polyether sulfone resin, a polyphenylene ether resin, a polycarbonate resin, a polyether ether ketone resin, and a polyester resin. (C) The thermoplastic resin may be used singly or as a combination of two or more of these resins.

Examples of the phenoxy resin may include those containing one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The phenoxy resin may be terminated with any functional group, such as a phenolic hydroxyl group or an epoxy group. Specific examples of the phenoxy resin may include "1256" and "4250" (both phenoxy resins containing a bisphenol A skeleton) manufactured by Mitsubishi Chemical Corp.; "YX8100" (phenoxy resin containing a bisphenol S skeleton) manufactured by Mitsubishi Chemical Corp.; "YX6954" (phenoxy resin containing a bisphenol acetophenone skeleton) manufactured by Mitsubishi Chemical Corp.; "FX280" and "FX293" manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482", and "YL7891BH30", all being manufactured by Mitsubishi Chemical Corp.

Specific examples of the polyimide resin may include "SLK-6100" manufactured by Shin-Etsu Chemical Co., Ltd.; and "Rikacoat SN20" and "Rikacoat PN20" manufactured by New Japan Chemical Co., Ltd. Specific examples of the polyimide resin may include a linear polyimide obtained by reacting a bifunctional hydroxyl group-terminated polybutadiene, a diisocyanate compound, and a tetrabasic acid anhydride (polyimide described in Japanese Patent Application Laid-open No. 2006-37083), and modified polyimides such as the polyimides containing a polysiloxane skeleton (polyimides described in Japanese Patent Application Laid-open No. 2002-12667 and Japanese Patent Application Laid-open No. 2000-319386).

Illustrative examples of the polyvinyl acetal resin may include a polyvinylformal resin and a polyvinyl butyral resin; here, the polyvinyl butyral resin is preferable. Specific examples of the polyvinyl acetal resin may include "Denka Butyral 4000-2", "Denka Butyral 5000-A", "Denka Butyral 6000-C", and "Denka Butyral 6000-EP", all of them being manufactured by Denka Company Limited; and the S-LEC BH series, the BX series (e.g., BX-5Z), the KS series (e.g., KS-1), the BL series, and the BM series, all of them being manufactured by Sekisui Chemical Co., Ltd.

Illustrative examples of the polyolefin resin may include low-density polyethylene, ultra-low-density polyethylene, high-density polyethylene, ethylene copolymers such as an ethylene-vinyl acetate copolymer, an ethylene-ethyl acrylate copolymer, and an ethylene-methyl acrylate copolymer; and polyolefin polymers such as polypropylene and an ethylene-propylene block copolymer.

Illustrative examples of the polybutadiene resin may include a resin containing a hydrogenated polybutadiene skeleton, a polybutadiene resin containing a hydroxy group, a polybutadiene resin containing a phenolic hydroxyl group, a polybutadiene resin containing a carboxy group, a polybutadiene resin containing an acid anhydride group, a polybutadiene resin containing an epoxy group, a polybutadiene resin containing an isocyanate group, a polybutadiene resin containing a urethane group, and a polyphenylene ether-polybutadiene resin.

Specific examples of the polyamide imide resin may include "Vyromax HR11NN" and "Vyromax HR16NN", both being manufactured by Toyobo Co., Ltd. Specific examples of the polyamide imide resin may include modified polyamide imides such as "KS9100" and "KS9300" (polyamide imide containing a polysiloxane skeleton) manufactured by Hitachi Chemical Co., Ltd.

Specific examples of the polyethersulfone resin may include "PES5003P" manufactured by Sumitomo Chemical Co., Ltd.

Specific examples of the polysulfone resin may include polysulfone "P1700" and "P3500", both being manufactured by Solvay Advanced Polymers, Inc.

Specific examples of the polyphenylene ether resin may include "NORYL SA90" manufactured by SABIC. Specific examples of the polyether imide resin may include "Ultem" manufactured by GE.

Illustrative examples of the polycarbonate resin may include a hydroxy group-containing carbonate resin, a phenolic hydroxy group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin may include "FPC0220" manufactured by Mitsubishi Gas Chemical Co. Ltd., "T6002" and "T6001" (polycarbonate diol) manufactured by Asahi Kasei Chemicals; and "C-1090", "C-2090", and "C-3090" (polycarbonate diol) manufactured by Kuraray Co., Ltd. Specific examples of the polyether ether ketone resin may include "Sumiploy K" manufactured by Sumitomo Chemical Co., Ltd.

Illustrative examples of the polyester resin may include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexanedimethyl terephthalate resin.

The weight-average molecular weight (Mw) of (C) the thermoplastic resin is preferably more than 5,000, more preferably 8,000 or more, still more preferably 10,000 or more, and especially preferably 20,000 or more. The upper limit thereof is not partilucarly limited, and may be, for example, 1,000,000 or less, 500,000 or less, or 100,000 or less.

The amount (% by mass) of the (C) the thermoplastic resin included in the resin composition is preferably 0.01% or more by mass, more preferably 0.05% or more by mass, and especially preferably 0.1% or more by mass, and is preferably 5% or less by mass, more preferably 3% or less by mass, and especially preferably 2% or less by mass, relative to 100% by mass of the nonvolatile components in the resin composition. When the amount of (C) the thermoplastic resin is in the aforementioned range, the magnetic properties and the polishing workability of the cured product of the resin composition can be particularly improved.

The amount (% by volume) of the (C) the thermoplastic resin included in the resin composition is preferably 0.1% or more by volume, more preferably 1% or more by volume, and especially preferably 2% or more by volume, and is preferably 20% or less by volume, more preferably 10% or less by volume, and especially preferably 5% or less by volume, relative to 100% by volume of the nonvolatile components in the resin composition. When the amount of (C) the thermoplastic resin is in the aforementioned range, the magnetic properties and the polishing workability of the cured product of the resin composition can be particularly improved.

The amount (% by mass) of (C) the thermoplastic resin included in the resin composition is preferably 1% or more by mass, more preferably 5% or more by mass, and especially preferably 10% or more by mass, and is preferably 40% or less by mass, more preferably 30% or less by mass, and especially preferably 20% or less by mass, relative to 100% by mass of the resin components in the resin composition. When the amount of (C) the thermoplastic resin is in the aforementioned range, the magnetic properties and the polishing workability of the cured product of the resin composition can be particularly improved.

The mass ratio M(C)/M(A-1) between the mass M(A-1) of (A-1) the small diameter magnetic powder and the mass M(C) of (C) the thermoplastic resin in the resin composition is preferably within a particular range. Specifically, the range of the mass ratio M(C)/M(A-1) is preferably 0.019 or more, more preferably 0.020 or more, and especially preferably 0.021 or more, and is preferably 0.095 or less, more preferably 0.090 or less, and especially preferably 0.080 or less. When the mass ratio M(C)/M(A-1) is in the aforementioned range, the magnetic properties and the polishing workability of the cured product of the resin composition can be particularly improved.

The volume ratio V(C)/V(A-1) between the volume V(A-1) of (A-1) the small diameter magnetic powder and the volume V(C) of (C) the thermoplastic resin in the resin composition is preferably in a particular range. Specifically, the range of the volume ratio V(C)/V(A-1) is preferably 0.080 or more, more preferably 0.085 or more, and especially preferably 0.090 or more, and is preferably 0.40 or less, more preferably 0.38 or less, and especially preferably 0.35 or less. When the volume ratio V(C)/V(A-1) is in the aforementioned range, the magnetic properties and the polishing workability of the cured resin composition can be particularly improved.

### [5. (D) Dispersant]

The resin composition according to one embodiment of the present invention may further include (D) a dispersant as an optional component in combination with the components (A) to (C) described above. (D) The dispersant as a component (D) does not include those that fall under the components (A) to (C) described above. (D) The dispersant can effectively enhance the dispersibility of (A) the magnetic powder; thus, embedding property of the resin composition into the through hole can be particularly improved.

As for (D) the dispersant, a compound that can reduce the viscosity of the resin composition may be used. Illustrative examples of (D) the dispersant may include a phosphate ester type dispersant, a polyoxyalkylene type dispersant, an acetylene type dispersant, a silicone type dispersant, an anionic dispersant, and a cationic dispersant. (E) The dispersant may be used singly or as a combination of two or more of these dispersants. Among these, the phosphate ester type dispersant is preferable.

Among the phosphate ester type dispersants, a polyether type phosphate ester dispersant is preferable. The polyether type phosphate dispersant is the phosphate ester type dispersant containing a poly(alkyleneoxy) structure in the molecule. Illustrative examples of the polyether type phosphate dispersant may include a polyoxyalkylene alkyl ether phosphate and a polyoxyalkylene alkyl phenyl ether phosphate. Among these, the polyoxyalkylene alkyl ether phosphate is especially preferable.

The polyoxyalkylene alkyl ether phosphate may have a structure in which one to three alkyl-oxy-poly(alkyleneoxy) groups are bonded to the phosphorous atom of the phosphate salt. The number of alkyleneoxy units (number of repeating units) of the poly(alkyleneoxy) moiety in the alkyl-oxy-poly(alkyleneoxy) group is preferably 2 to 30, and more preferably 3 to 20. The alkylene group in the poly(alkyleneoxy) moiety is preferably an alkylene group having 2 to 4 carbon atoms. Illustrative examples of the alkylene group may include an ethylene group, a propylene group, an isopropylene group, a butylene group, and an isobutyl group. Furthermore, the alkyl group in the alkyl-oxy-poly(alkyleneoxy) group is preferably an alkyl group having 6 to 30 carbon atoms, and more preferably an alkyl group having 8 to 20 carbon atoms. Illustrative examples of the alkyl group may include a decyl group, an undecyl group, a dodecyl group, a tridecyl group, a tetradecyl group, a pentadecyl group, a hexadecyl group, a heptadecyl group, and an octadecyl group. When the polyoxyalkylene alkyl ether phosphate has a plurality of alkyl-oxy-poly(alkyleneoxy) groups, a plurality of alkyl groups may be the same or different. Furthermore, a plurality of alkylene groups may be the same or different.

The acid value of the polyether type phosphate dispersant is preferably 10 or more, and more preferably 15 or more, and is preferably 200 or less, and more preferably 150 or less. The acid value may be measured by the neutralization titration method.

Illustrative examples of the commercially available phosphate ester type dispersant may include polyether type phosphate ester dispersants (e.g., "ED152", "ED153", "ED154", "ED118", "ED174", and "ED251" of the HIPLAAD series), all being manufactured by Kusumoto Chemicals, Ltd.; and "RS-410", "RS-610", and "RS-710" of the Phosphanol series manufactured by Toho Chemical Industry Co., Ltd.

Illustrative examples of the polyoxyalkylene type dispersant may include a polyoxyethylene alkyl ether, a polyoxyethylene alkyl ester, a polyoxyethylene sorbitan fatty acid ester, a polyoxyethylene alkyl phenyl ether, a polyoxyethylene alkylamine, and a polyoxyethylene alkylamide. Illustrative examples of the commercially available polyoxyalkylene type dispersant may include "AKM-0531", "AFB-1521", "SC-0505K", "SC-1015F", "SC-0708A", and "HKM-50A" of the "Malialim" series manufactured by NOF Corp.

Illustrative examples of the acetylene type dispersant may include acetylene glycol. Illustrative examples of the commercially available acetylene type dispersant may include "82", "104", "440", "465", "485", and "Olefin Y" of the "Surfynol" series manufactured by Air Products and Chemicals Inc.

Illustrative examples of the silicone type dispersant may include polyether-modified polydimethylsiloxane, polyether-modified siloxane, and polyester-modified polydimethylsiloxane. Illustrative examples of the commercially available silicone type dispersant may include "BYK 347" and "BYK 348", both being manufactured by BYK Chemie GmbH.

Illustrative examples of the anionic dispersant may include sodium polyacrylate, sodium dodecylbenzyl sulfonate, sodium laurylate, ammonium polyoxyethylene alkyl ether sulfate, and sodium carboxymethyl cellulose salt. Illustrative examples of the commercially available anionic dispersant may include "PN-411" and "PA-111", both being be manufactured by Ajinomoto Fine-Techno Co., Inc.; and "A-550" and "PS-1900", both being manufactured by Lion Corp.

Illustrative examples of the cationic dispersant may include a polyacrylate type resin containing an amino group and a polystyrene type resin containing an amino group. Illustrative examples of the commercially available cationic dispersant may include "161", "162", "164", "182", "2000", and "2001", all being manufactured by BYK Chemie GmbH; "PB-821", "PB-822", and "PB -824", all being manufactured by Ajinomoto Fine-Techno Co., Inc.; "V-216" and "V-220", both being manufactured by ISP Japan, Ltd.; and "SOLSPERSE 13940", "SOLSPERSE 24000", and "SOLSPERSE 32000", all being manufactured by Lubrizol, Inc.

(D) The dispersant may be used singly or as a combination of two or more of these dispersants.

The amount (% by mass) of (D) the dispersant included in the resin composition is preferably 0.01% or more by mass, more preferably 0.1% or more by mass, and especially preferably 0.2% or more by mass, and is preferably 5% or less by mass, more preferably 3% or less by mass, and especially preferably 2% or less by mass, relative to 100% by mass of the nonvolatile components in the resin composition. When the amount of (D) the dispersant is in the aforementioned range, the magnetic properties and the polishing workability of the cured product of the resin composition can be particularly improved.

The amount (% by volume) of (D) the dispersant included in the resin composition is preferably 0.1% or more by volume, more preferably 0.5% or more by volume, and especially preferably 1% or more by volume, and is preferably 20% or less by volume, more preferably 10% or less by volume, and especially preferably 5% or less by volume, relative to 100% by volume of the nonvolatile components in the resin composition. When the amount of (D) the dispersant is in the aforementioned range, the magnetic properties and the polishing workability of the cured product of the resin composition can be particularly improved.

The amount (% by mass) of (D) the dispersant included in the resin composition is preferably 1% or more by mass, more preferably 5% or more by mass, and especially preferably 10% or more by mass, and is preferably 40% or less by mass, more preferably 30% or less by mass, and especially preferably 20% or less by mass, relative to 100% by mass of the resin components in the resin composition. When the amount of (D) the dispersant is in the aforementioned range, the magnetic properties and the polishing workability of the cured product of the resin composition can be particularly improved.

The mass ratio M(D)/M(A-1) between the mass M(A-1) of (A-1) the small diameter magnetic powder and the mass M(D) of (D) the dispersant included in the resin composition is preferably within a particular range. Specifically, the range of the mass ratio M(D)/M(A-1) is preferably 0.016 or more, more preferably 0.017 or more, and especially preferably 0.018 or more, and is preferably 0.080 or less, more preferably 0.070 or less, and especially preferably 0.065 or less. When the mass ratio M(D)/M(A-1) is in the aforementioned range, the magnetic properties and the polishing workability of the cured product of the resin composition can be particularly improved.

The volume ratio V(D)/V(A-1) between the volume V(A-1) of (A-1) the small diameter magnetic powder and the volume V(D) of (D) the dispersant included in the resin composition is preferably within a particular range. Specifically, the range of the volume ratio V(D)/V(A-1) is preferably 0.080 or more, more preferably 0.085 or more, and especially preferably 0.090 or more, and is preferably 0.42 or less, more preferably 0.38 or less, and especially preferably 0.35 or less. When the volume ratio V(D)/V(A-1) is in the aforementioned range, the magnetic properties and the polishing workability of the cured product of the resin composition can be particularly improved.

### [6. (E) Curing Facilitator]

The resin composition according to one embodiment of the present invention may further include (E) a curing facilitator as an optional component in combination with the components (A) to (D) described above. (E) The curing facilitator as a component (E) does not include those that fall under the components (A) to (D) described above. (E) The curing facilitator functions as a catalyst to facilitate curing of (B-1) the epoxy resin so that this can facilitate curing of the resin composition.

Illustrative examples of (E) the curing facilitator may include a phosphorous type curing facilitator, an amine type curing facilitator, an imidazole type curing facilitator, a guanidine type curing facilitator, and a metal type curing facilitator. In particular, the imidazole type curing facilitator is preferable. (E) The curing facilitator may be used singly or as a combination of two or more of these facilitators.

Illustrative examples of the imidazole type curing facilitator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin. Among these, 2-ethyl-4-methylimidazole and 1-benzyl-2-phenylimidazole are preferable. Commercially available products may be used as the imidazole type curing facilitator. Illustrative examples thereof may include "P200-H50" manufactured by Mitsubishi Chemical Corp.; "Curezol 2MZ", "2E4MZ", "Cl1Z", "Cl1Z-CN", "Cl1Z-CNS", "Cl1Z-A", "2MZ-OK", "2MA-OK", "2MA-OK-PW, and "2PHZ", which are all manufactured by Shikoku Chemicals Corp.

Illustrative examples of the amine type curing facilitator may include: trialkylamines such as triethylamine and tributylamine; and 4-dimethylaminopyridine, benzyl dimethyl amine, 2,4,6-tris(dimethylaminomethyl)phenol, 1,8-diazabicyclo(5,4,0)-undecene, 1,8-diazabicyclo[5,4,0]undecene-7,4-dimethylaminopyridine, and 2,4,6-tris(dimethylaminomethyl)phenol. Among these, 4-dimethylaminopyridine is preferable.

Illustrative examples of the phosphorous type curing facilitator may include triphenyl phosphine, a phosphonium borate compound, tetraphenyl phosphonium tetraphenyl borate, n-butyl phosphonium tetraphenyl borate, tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and tetrabutyl phosphonium decanoate salt are preferable.

Illustrative examples of the guanidine type curing facilitator may include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]dec-5-ene, 7-methyl-1,5,7-triazabicyclo[4.4.0]dec-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]dec-5-ene are preferable.

Illustrative examples of the metal type curing facilitator may include organometallic complexes or organometallic salts of metals such as cobalt, copper, zinc, iron, nickel, manganese, and tin. Specific examples of the organometallic complex may include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt may include zinc octylate, tin octylate, zinc naphthenate, cobalt naphthenate, tin stearate, and zinc stearate.

The amount (% by mass) of (E) the curing facilitator included in the resin composition is preferably 0.001% or more by mass, more preferably 0.005% or more by mass, and especially preferably 0.01% or more by mass, and is preferably 1% or less by mass, more preferably 0.5% or less by mass, and especially preferably 0.1% or less by mass, relative to 100% by mass of the nonvolatile components in the resin composition.

The amount (% by mass) of (E) the curing facilitator included in the resin composition is preferably 0.01% or more by mass, more preferably 0.05% or more by mass, and especially preferably 0.1% or more by mass, and is preferably 2.0% or less by mass, more preferably 1.0% or less by mass, and especially preferably 0.5% or less by mass, relative to 100% by mass of the resin components in the resin composition.

### [7. (F) Optional Additive]

The resin composition according to one embodiment of the present invention may further include (F) an optional additive as an optional component in combination with the components (A) to (E) described above. (F) The optional additive as a (F) component does not include those that fall under the components (A) to (E) described above.

Illustrative examples of (F) the optional component may include: radical-polymerizable compounds such as a maleimide type radical-polymerizable compound, a vinylphenyl type radical-polymerizable compound, a (meth)acrylic type radical-polymerizable compound, an allyl type radical-polymerizable compound, and a polybutadiene type radical-polymerizable compound; radical polymerization initiators such as a peroxide type radical polymerization initiator and an azo type radical polymerization initiator; inorganic fillers such as a silica particle; organic fillers such as a rubber particle; organic metal compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. (F) The optional additive may be used singly or as a combination of two or more of these components.

### [8. (G) Solvent]

The resin composition according to one embodiment of the present invention may further include (G) a solvent as a volatile component in combination with the nonvolatile components such as the components (A) to (F) described above.

An organic solvent is usually used as (G) the solvent. Illustrative examples of the organic solvent may include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. (G) The solvent may be used singly or as a combination of two or more of these solvents.

The amount of (G) the solvent is set preferably so that the melt viscosity of the resin composition or the resin composition layer including the resin composition can be adjusted to an appropriate range. The resin composition does not have to contain (G) the solvent.

### [9. Characteristics of the Resin Composition]

The resin composition described above can be cured by heat. Therefore, a cured product of the resin composition can be obtained by thermally curing the resin composition. Normally, among the components included in the resin composition, volatile components such as (G) the solvent may be volatilized by heat during thermal curing, while non-volatile components such as the components (A) to (F) are not volatilized by heat during thermal curing. Thus, the cured product of the resin composition may contain non-volatile components of the resin composition or reaction products thereof.

The cured product of the aforementioned resin composition has an excellent polishing workability. Therefore, the magnetic layer comprising the cured product can also have an excellent polishing workability. For example, in the cured product obtained by thermally curing the resin composition, the polishing amount per unit time can be usually increased. Therefore, when the magnetic layer is obtained by thermally curing the resin composition, the thickness reduction of the magnetic layer per unit time of polishing can be increased. Furthermore, the cured product of the resin composition and the magnetic layer comprising the cured product can usually suppress breakage such as cracking and chipping when polishing is performed as described above. Polishing workability can be evaluated, for example, by forming and polishing the magnetic layer, measuring the polishing amount, and observing the breakage in accordance with the method described in Examples below.

The cured product of the resin composition described above can have excellent magnetic properties. Therefore, the magnetic layer comprising the cured product thereof can also have excellent magnetic properties. Specifically, the cured product of the resin composition and the magnetic layer comprising the cured product can usually have a high relative magnetic permeability and a low magnetic loss.

For example, the cured product obtained by thermally curing the resin composition under thermal curing conditions at 190°C for 90 minutes can have a relative magnetic permeability in a particular range. Therefore, the magnetic layer obtained by thermally curing the resin composition layer under the aforementioned thermal curing conditions can also have a relative magnetic permeability in the particular range. Specifically, the particular range of the relative magnetic permeabilities of the cured product of the resin composition and the magnetic layer is preferably 5 or more, more preferably 7 or more, still more preferably 9 or more, and especially preferably 11 or more, with the measurement frequency of 20 MHz and at room temperature of 23°C. There is no particular restriction in the upper limit; the upper limit may be, for example, 30 or less. Specifically, the relative magnetic permeability may be measured by the method to be explained later in Examples.

The cured product obtained by thermally curing the resin composition under thermal curing conditions at 190°C for 90 minutes can have a magnetic loss in a particular range. Therefore, the magnetic layer obtained by thermally curing the resin composition layer under the aforementioned thermal curing conditions can also have a magnetic loss in the particular range. The particular range of the magnetic loss of the cured product and the magnetic layer is preferably 0.10 or less, more preferably 0.08 or less, still more preferably 0.06 or less, and especially preferably 0.05 or less, with the measurement frequency of 20 MHz and at room temperature of 23°C. The lower limit is ideally 0.00 or more, and usually 0.01 or more. Specifically, the magnetic loss may be measured by the method to be described later in Examples.

From the viewpoint of utilizing the advantages described above, it is preferable to use the resin composition as the composition for filling the through hole in the core substrate. Specifically, the resin composition is preferably used as the material for the resin composition layer of the resin sheet for filling of the through hole. When laminating the core substrate with the resin sheet, a portion of the resin composition layer enters into the through hole so that the through hole can be filled with the resin composition. By curing the resin composition, the magnetic layer can then be formed in the through hole.

### [10. Production Method of the Resin Composition]

The resin composition according to one embodiment of the present invention can be produced, for example, by mixing the above-mentioned components. The aformentioned components may be mixed in part or in whole at the same time or in sequence. During the course of mixing of each component, the temperature may be set as appropriate; therefore, temporarily or throughout the entire process, heating and/or cooling may be carried out. In addition, in the course of mixing of each component, stirring or shaking may be carried out.

### [11. Resin Sheet]

The resin sheet according to one embodiment of the present invention includes a resin composition layer. The resin composition layer contains the resin composition described above, and contains preferably only the resin composition. The resin composition layer preferably has a thickness that can fill the through hole in the core substrate. Specifically, the thickness of the resin composition layer is preferably 5 um or more, more preferably 10 um or more, and especially preferably 50 um or more, and is preferably 600 um or less, more preferably 300 µm or less, and especially preferably 200 µm or less, although these may be different depending on the thickness of the core substrate and the size of the through hole.

The resin composition layer usually has excellent filling properties. Therefore, when the core substrate having the through hole is laminated with the resin sheet including the resin composition layer, the resin composition layer can smoothly fill the through hole. More specifically, because the lamination of the core substrate with the resin sheet is usually performed with applying a heat and a pressure, the resin composition layer, whose fluidity is increased by the heat, can enter into the through hole by the pressure so that the through hole can be filled smoothly. When the through hole is filled by laminating the core substrate with the resin sheet, liquid dripping of the resin composition from the through hole can be suppressed. Furthermore, by curing the resin composition layer, the magnetic layer having improved polishing workability and excellent magnetic properties can be obtained as described above.

The resin composition layer can be produced, for example, by a method that includes applying the resin composition onto a support surface. The resin composition layer can be produced by a method that includes, for example, preparing a resin varnish in which the resin composition is dissolved or dispersed in a solvent, applying the resin varnish onto a support surface, and drying the applied resin varnish, in this order. For example, the surface of the support to be described later may be used as the support surface. (G) The solvent described above may be used as the solvent.

Application may be performed using a coating equipment such as a die coater. Drying may be carried out, for example, by a drying method such as heating or blowing with a hot air. The drying condition is not particularly restricted. Drying is carried out in such a way as to bring the content of the solvent in the resin composition layer preferably to 10% or less by mass, and more preferably to 5% or less by mass. Drying may be carried out, for example, under conditions of 50°C to 150°C and 3 minutes to 10 minutes, although these conditions vary depending on the boiling point of the solvent in the resin varnish.

The resin sheet according to one embodiment of the invention may include a support in combination with the resin composition layer. Normally, since the resin composition layer is formed on the support, the support and the resin composition layer are directly contact with each other, and other member is not disposed therebetween. Illustrative examples of the support may include a film formed of a plastic material, metal foil, and a releasing paper. Among them, the film formed of a plastic material and metal foil are preferable.

In the case that the film formed of a plastic material is used as the support, illustrative examples of the plastic material may include: polyesters such as polyethylene terephthalate (hereinafter, this may be simply called "PET") and polyethylene naphthalate (hereinafter, this may be simply called "PEN"); polycarbonate (hereinafter, this may be simply called "PC"); acryl polymers such as polymethyl methacrylate (hereinafter, this may be simply called "PMMA"); a cyclic polyolefin; triacetyl cellulose (hereinafter, this may be simply called "TAC"); polyether sulfide (hereinafter, this may be simply called "PES"); polyether ketone; and polyimide. Among these, polyethylene terephthalate and polyethylene naphthalate are preferable; inexpensive polyethylene terephthalate is especially preferable.

In the case that metal foil is used as the support, illustrative examples of the metal foil may include copper foil and aluminum foil. Among them, the copper foil is preferable. As for the copper foil, the foil formed of a copper single metal or an alloy of copper with other metal (for example, tin, chromium, silver, magnesium, nickel, zirconium, silicon, and titanium) may be used.

The support may have been subjected to a treatment such as a mat treatment, a corona treatment, and an antistatic treatment, on the surface to be bonded with the resin composition layer.

As for the support, a releasing layer-attached support having a releasing layer on the surface to be bonded with the resin composition layer may be used. The releasing agent to be used in the releasing layer of the releasing layer-attached support may be one or more releasing agents selected from the group consisting of, for example, an alkyd resin, a polyolefin resin, a urethane resin, and a silicone resin. Illustrative examples of the commercially available releasing agent may include alkyd resin-based releasing agents such as "SK-1", "AL-5", and "AL-7", all being manufactured by Lintec Inc. Illustrative examples of the releasing layer-attached support may include "Lumirror T60" manufactured by Toray Industries, Inc.; "PUREX" manufactured by Teijin Limited; and "UNIPEEL" manufactured by Unitika, Ltd.

The thickness of the support is not particularly restricted; the thickness is preferably 1 um or more, more preferably 5 um or more, and still more preferably 10 um or more, and is preferably 75 um or less, more preferably 60 um or less, still more preferably 50 um or less, and especially preferably 40 µm or less.

The resin sheet may further contain an optional member as needed. Illustrative examples of the optional member may include a protective film, which is formed on the surface of the resin composition layer not being contact with the support (namely, on the surface opposite to the support). The thickness of the protective film is not particularly restricted; the thickness is, for example, 1 um to 40 um. When the protective film is formed, the surface of the resin composition layer can be prevented from attachment of dirt and formation of a scar. When the resin sheet includes the protective film, usually the resin sheet can be used by removing the protective film. The resin sheet can be rolled up so as to be stored.

The resin sheet can be produced, for example, by a method that includes forming the resin composition layer on the support. The resin composition layer can be formed by the resin composition layer production method described before.

The resin sheet is preferably used for filling the through hole in the core substrate. When the core substrate having the through hole is laminated with the resin sheet, and a portion of the resin composition layer enters into the through hole, the through hole can be filled with the resin composition. The magnetic layer can then be formed in the through hole by curing the resin composition. Because the magnetic layer formed includes the cured product of the resin composition described above, the magnetic layer can have improved polishing workability and excellent magnetic properties. Therefore, according to the resin sheet, a circuit board including the magnetic layer having excellent magnetic properties can be smoothly produced.

### [12. Circuit Board]

The circuit board according to one embodiment of the present invention includes the magnetic layer. This magnetic layer contains the cured product of the resin composition described above, and contains preferably only the cured product of the resin composition described above. A specific structure of the circuit board is not particularly restricted so far as the magnetic layer containing the cured product of the resin composition is provided. From the viewpoint of effectively utilizing the advantage of being able to fill the through hole while suppressing liquid dripping, a preferable example of the circuit board is the circuit board comprising the core substrate as the substrate formed with the through hole and the magnetic layer filled in the through hole. In this circuit board, the magnetic layer may be the cured product of the resin composition layer.

The circuit board according to the preferred example comprises the core substrate formed with the through hole and the magnetic layer filled in this through hole. This circuit board includes, for example, the following steps in this order:
(1) laminating a core substrate formed with a through hole and a resin sheet to fill the through hole with a portion of the resin composition layer,
(2) curing the resin composition layer to form a magnetic layer, and
(3) polishing the magnetic layer.
   The production method of the circuit board may also include an optional step in combination with the steps (1) through (3). For example, the production method of the circuit board may include the steps of
(4) applying a roughening treatment to the magnetic layer and
(5) forming a conductive layer on the magnetic layer. When both the step (4) and step (5) are performed, the step (5) is usually performed after the step (4).

### <Step (1)>

The step (1) usually includes the step of preparing the core substrate formed with the through hole. The core substrate may be prepared by purchasing from the market. Alternatively, the core substrate may be prepared by production using a suitable material. Hereinafter, the production method of the core substrate according to one example will be described.

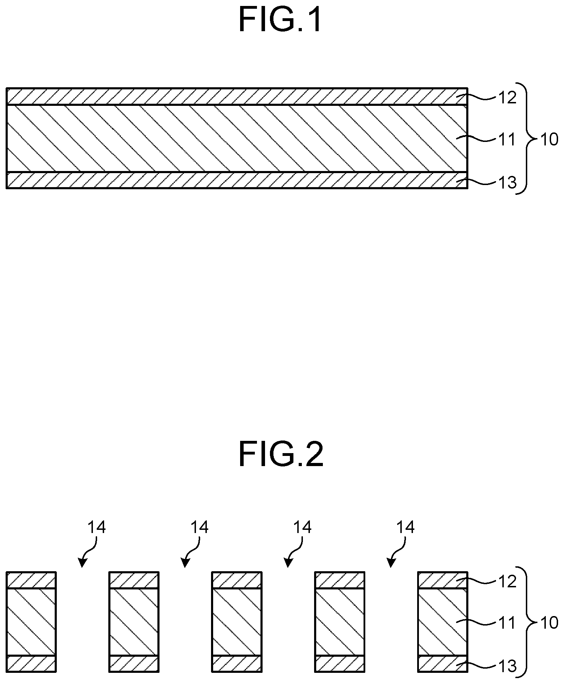

FIG. 1 is a schematic cross sectional view illustrating the core substrate 10 before forming a through hole in the production method of the circuit board according to one embodiment of the present invention. The step of preparing the core substrate 10 may include the step of preparing the core substrate 10 not formed with the through hole to be filled with the magnetic layer, as illustrated in FIG. 1. This core substrate 10 is the substrate before forming the through hole; here, this may be a plate member.

The core substrate 10 usually includes a supporting substrate 11. Illustrative examples of the supporting substrate 11 may include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both the surfaces thereof. Here, the example is illustrated in which a metal layer 12 and a metal layer 13 are formed on both the surfaces of the supporting substrate 11. Illustrative examples of the metal layers 12 and 13 may include a layer formed of a metal such as copper. The metal layers 12 and 13 may be, for example, copper foil such as carrier-attached copper foil, or a metal layer formed of the material of the conductive layer that will be described later.

FIG. 2 is a schematic cross sectional view illustrating the core substrate 10 formed with the through hole 14 in the production method of the circuit board according to one embodiment of the present invention. As illustrated in FIG. 2, the step of preparing the core substrate 10 may include the step of forming the through hole 14 in the core substrate 10. The through hole 14 may be formed, for example, by drilling, laser irradiation, or plasma irradiation. The through hole 14 can usually be formed by forming a penetrating hole through the core substrate 10. In a specific example, formation of the through hole 14 may be carried out by using a drilling machine that is commercially available. Illustrative examples of the commercially available drilling machine may include "ND-1S211" manufactured by Hitachi Via Mechanics, Ltd.

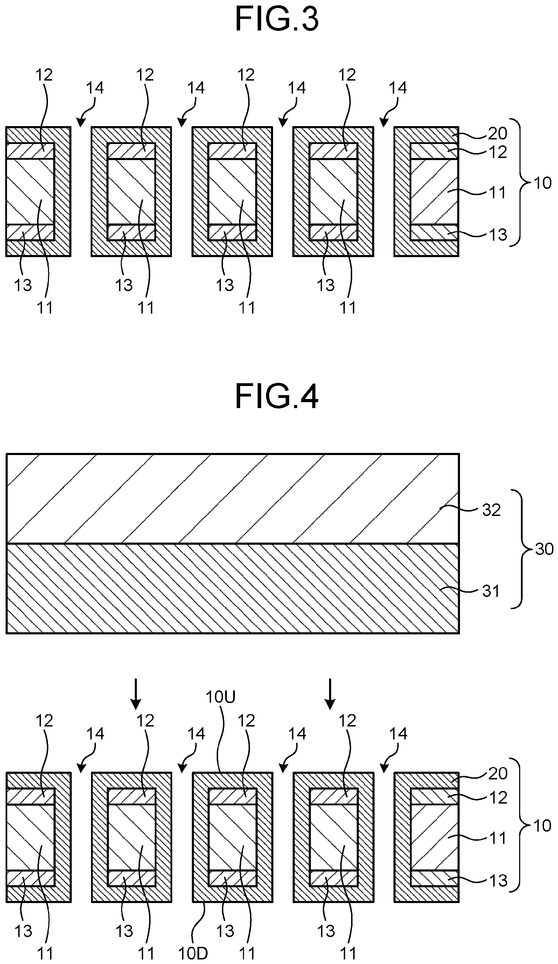

FIG. 3 is a schematic cross sectional view illustrating the core substrate 10 formed with a plated layer 20 in the through hole 14 in the production method of the circuit board according to one embodiment of the present invention. After the core substrate 10 is subjected to a roughening treatmet as needed, the step of preparing the core substrate 10 may include the step of forming the plated layer 20, as illustrated in FIG. 3. The roughening treatment may be carried out with any of a dry roughening treatment and a wet roughening treatment. Illustrative examples of the dry roughening treatment may include a plasma treatment. Illustrative examples of the wet roughening treatment may include a method in which a swelling treatment by a swelling liquid, a roughening treatment by an oxidant, and a neutralizing treatment by a neutralizing solution are carried out in this order. The plated layer 20 may be formed by a plating method. The procedure to form the plated layer 20 by the plating method may be the same as that in formation of the conductive layer at the step (5) described later. Here, the explanation will be made as to the example in which the plated layer 20 is formed inside the through hole 14, on the surface of the metal layer 12, and on the surface of the metal layer 13. In this example, the core substrate formed with the plated layer 20 is described with the same code "10" as the core substrate 10 before forming the plated layer 20.

FIG. 4 is a schematic cross sectional view illustrating the state of the lamination of the core substrate 10 and a resin sheet 30 in the production method of the circuit board according to one embodiment of the present invention. As illustrated in FIG. 4, the step (1) includes, after the core substrate 10 formed with the through hole 14 is prepared, laminating the core substrate 10 and the resin sheet 30. In this embodiment, the example of laminating the resin sheet 30 comprising a resin composition layer 31 and a support 32 on one surface 10U of the core substrate 10 is illustrated. In the following description, the surface 10U of the core substrate 10 that is bonded to the resin sheet 30 may be referred to as "first surface 10U", and the opposite surface may be refferd to as "second surface 10D".

Lamination of the core substrate 10 and the resin sheet 30 is performed so that part of the resin composition layer 31 is filled into the through hole 14. Therefore, lamination is usually performed so that the resin composition layer 31 and the core substrate 10 are bonded. Specifically, the aforementioned lamination can be performed by thermal-pressing the resin sheet 30 onto the core substrate 10 to bond the resin composition layer 31 onto the core substrate. When the resin sheet 30 includes the support 32, as in the example illustrated in FIG. 4, the aforementioned lamination may be done by pressing the resin sheet 30 from the side of the support 32 onto the core substrate 10. Illustrative examples of the member used for thermal-pressing (hereinafter, this may be referred to as "thermal-pressing member", not illustrated in the drawing) may include a heated metal plate (such as a SUS mirror plate) and a metal roll (such as a SUS roll). Here, the thermal-pressing member may be pressed in direct contact with the resin sheet 30, but it is preferable that the pressing is made via an elastic material such as a heat-resistant rubber in such a way that the resin sheet 30 can well follow the irregularity on the surface of the core substrate 10.

Lamination of the core substrate 10 and the resin sheet 30 may be conducted, for example, by a vacuum lamination method. Lamination conditions (thermal-pressing conditions) may be, for example, as follows. The thermal-pressing temperature is preferably 60°C to 160°C, and more preferably 80°C to 140°C. The pressure of the thermal-pressing is preferably 0.098 MPa to 1.77 MPa, and more preferably 0.29 MPa to 1.47 MPa. The period of the thermal-pressing is preferably 20 seconds to 400 seconds, and more preferably 30 seconds to 300 seconds. The lamination is carried out under a reduced pressure, preferably 13 hPa or less.

After the lamination, the laminated resin sheet 30 may be flattened by pressing the thermal-pressing member from the side of the support 32 under a normal pressure (under an atmospheric pressure). The pressing conditions of the flattening process may be the same as the thermal-pressing conditions in the before-mentioned lamination. The lamination and the flattening processes may be carried out continuously by using a commercially available vacuum laminator.

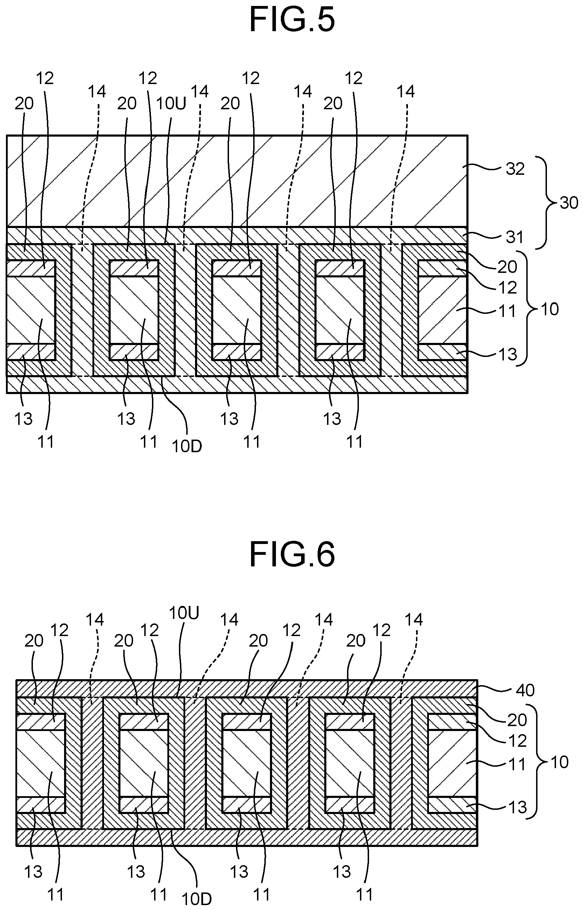

FIG. 5 is a schematic cross sectional view illustrating the state of the lamination of the core substrate 10 and the resin sheet 30 in the production method of the circuit board according to one embodiment of the present invention. The lamination of the core substrate 10 and the resin sheet 30 causes a portion of the resin composition layer 31 of the resin sheet 30 to enter the through hole 14, as illustrated in FIG. 5, so that the through hole 14 is filled with the resin composition layer 31. Another portion of the resin composition layer 31 does not normally enter the through hole 14; so it adheres onto the first surface 10U of the core substrate 10. Thus, the resin composition layer 31 may be formed on the first surface 10U of the core substrate 10. In addition, yet another portion of the resin composition layer 31 that has entered the through hole 14 may pass through the through hole 14 and be dispensed from an opening on the side of the second surface 10D of the core substrate 10. Therefore, the resin composition layer 31 may be formed on the second surface 10D of the core substrate 10.

Usually, the support 32 is removed after the lamination of the core substrate 10 and the resin sheet 30. In this embodiment, an example of removing the support 32 after lamination of the core substrate 10 with the resin sheet 30 and before the step (2) is illustrated and explained. However, removal of the support 32 may be performed after the step (2).

### <Step (2)>

FIG. 6 is a schematic cross sectional view to explain the step (2) in the production method of the circuit board according to one embodiment of the present invention. The step (2) includes curing the resin composition layer 31 after laminating the core substrate 10 and the resin sheet 30, as illustrated in FIG. 6. By curing the resin composition layer 31, a magnetic layer 40 containing the cured product of the resin composition can be formed. The magnetic layer 40 is formed in the through hole 14 and may usually be formed on the first surface 10U and the second surface 10D of the core substrate 10.

Curing of the resin composition 31 is usually carried out by thermal curing. Conditions of the thermal curing of the resin composition layer 31 may be set as appropriate so far as curing of the resin composition layer 31 can be proceeded. The curing temperature is preferably 60°C or higher, more preferably 70°C or higher, and still more preferably 80°C or higher, and is preferably 245°C or lower, more preferably 220°C or lower, and still more preferably 200°C or lower. The curing time is preferably 5 minutes or longer, more preferably 10 minutes or longer, and still more preferably 15 minutes or longer, and is preferably 120 minutes or shorter, more preferably 110 minutes or shorter, and still more preferably 100 minutes or shorter.

The curing degree of the magnetic layer 40 that is obtained at the step (2) is preferably 80% or more, more preferably 85% or more, and still more preferably 90% or more. The curing degree can be measured by using, for example, a differential scanning calorimeter.

The production method of the circuit board may include, after the core substrate 10 is laminated with the resin sheet 30 and before the resin composition layer 31 is cured, the step of heating the resin composition layer 31 at the temperature lower than the curing temperature thereof (preliminary heating step). For example, before curing the resin composition 31, the resin composition 31 may be preliminarily heated usually at a temperature of 50°C or higher and lower than 120°C (preferably 60°C or higher and 110°C or lower, and more preferably 70°C or higher and 100°C or lower) for the period of usually 5 minutes or longer (preferably 5 minutes to 150 minutes, and more preferably 15 minutes to 120 minutes).

### <Step (3)>

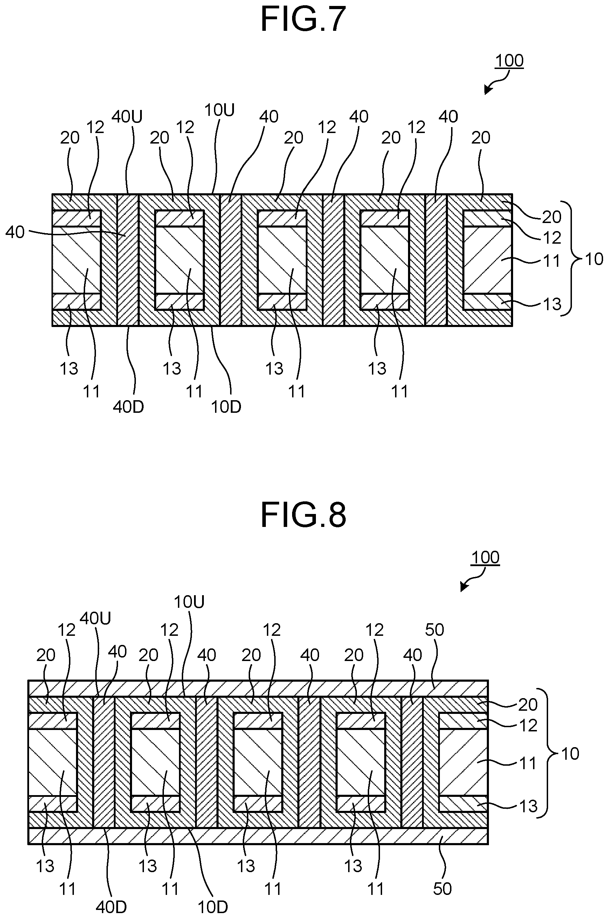

FIG. 7 is a schematic cross sectional view to explain the step (3) in the production method of the circuit board according to one embodiment of the present invention. The step (3) includes polishing the magnetic layer 40. Specifically, the step (3) includes polishing the magnetic layer 40 in the area outside the through hole 14. In the example illustrated in this embodiment, the magnetic layer 40 is formed on the first surface 10U and the second surface 10D of the core substrate 10, so that the magnetic layer 40 in the portions on those first surface 10U and the second surface 10D may be polished. The portion of the magnetic layer 40 outside of the through hole 14 is generally a surplus portion that is not needed in the final product. The aforementioned polishing can remove the surplus portion, as illustrated in FIG. 7. The polishing can also flatten the polished surfaces 40U and 40D as the surfaces of the magnetic layer 40.

As for the polishing method, a method that can remove unnecessary portions of the magnetic layer 40 may be employed. Illustrative examples of such a polishing method may include a buff polishing method, a belt polishing method, and a ceramic polishing method. Illustrative examples of the buff polishing equipment that is commercially available may include "NT-700IM" manufactured by Ishiihyoki Co., Ltd.

From a viewpoint of enhancing the adhesion with the conductive layer (not illustrated in FIG. 7), the arithmetic average roughness (Ra) of the polished surfaces 40U and 40D of the magnetic layer 40 is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) can be measured, for example, by using a non-contact type surface roughness meter.

After the step (2) and before the step (3), the magnetic layer 40 may be subjected to a heat treatment in order to further increase the curing degree of the magnetic layer 40. As for the temperature at this heat treatment, the above-mentioned curing temperature may be applied. Specifically, the temperature at the heat treatment is preferably 120°C or higher, more preferably 130°C or higher, and still more preferably 150°C or higher, and is preferably 245°C or lower, more preferably 220°C or lower, and still more preferably 200°C or lower. The heat-treatment period is preferably 5 minutes or longer, more preferably 10 minutes or longer, and still more preferably 15 minutes or longer, and is preferably 150 minutes or shorter, more preferably 120 minutes or shorter, and still more preferably 100 minutes or shorter.

By performing the steps (1) to (3) described above, a circuit board 100 including the core substrate 10 and the magnetic layer 40 that fills the through holes 14 of the core substrate 10 can be obtained. The circuit board 100 thus obtained may be subjected to the step (4) and the step (5) to form a conductive layer, as needed.

### <Step (4)>

The step (4) includes subjecting the the magnetic layer to a roughening treatment. Usually, the roughening treatment is applied to the polished surface of the magnetic layer. At the step (4), not only the polished surface of the magnetic layer but also the surfaces 10U and 10D of the core substrate 10 may be subjected to the roughening treatment.

The procedure and condition of the roughening treatment are not particularly restricted; for example, the procedure and condition that are used in the production method of a multilayer printed wiring board may be used. In a specific example, the roughening treatment may be carried out by the method including a swelling treatment with a swelling liquid, a roughening treatment with an oxidant, and a neutralization treatment with a neutralizing solution in this order.

Illustrative examples of the swelling liquid that can be used in the swelling treatment may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd.

The swelling treatment with the swelling liquid may be carried out, for example, by immersing the magnetic layer into the swelling liquid at 30°C to 90°C for the period of 1 minute to 20 minutes. From the viewpoint to suppress swelling of the resin included in the magnetic layer to a suitable level, it is preferable that the magnetic layer is immersed into the swelling liquid at 40°C to 80°C for the period of 5 minutes to 15 minutes.

Illustrative examples of the oxidant that can be used in the roughening treatment may include an alkaline permanganate solution having potassium permanganate or sodium permanganate dissolved into a sodium hydroxide aqueous solution. The roughening treatment using the oxidant such as the alkaline permanganate solution is preferably carried out by immersing the magnetic layer into the oxidant solution heated at 60°C to 80°C for the period of 10 minutes to 30 minutes. Concentration of the permanganate salt in the alkaline permanganate solution is preferably 5% by mass to 10% by mass. Illustrative examples of the oxidant that is commercially available may include alkaline permanganate solutions such as "Concentrate Compact P" and "Dosing Solution Securiganth P", which are manufactured by Atotech Japan, Co., Ltd.

The neutralizing solution that can be used in the neutralization treatment is preferably an acidic aqueous solution. Illustrative examples of commercially available product of the neutralizing solution may include "Reduction Solution Securiganth P", which is manufactured by Atotech Japan Co., Ltd. The neutralization treatment with the neutralizing solution may be carried out by immersing the surface, which has been treated with the roughening treatment using the oxidant solution, into the neutralizing solution at 30°C to 80°C for the period of 5 minutes to 30 minutes. From the viewpoint of workability and the like, it is preferable to immerse the magnetic layer, which has been treated with the roughening treatment using the oxidant solution, into the neutralizing solution at 40°C to 70°C for the period of 5 minutes to 20 minutes.

From a viewpoint to enhance the adhesion with the conductive layer, the arithmetic average roughness (Ra) of the surface of the magnetic layer after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) may be measured, for example, by using a non-contact type surface roughness meter.

### <Step (5)>

FIG. 8 is a schematic cross sectional view to explain the step (5) in the production method of the circuit board 100 according to one embodiment of the present invention. The step (5) includes forming a conductive layer 50 on the polished surfaces 40U and 40D of the magnetic layer 40, as illustrated in FIG. 8. In this embodiment, the example is illustrated in which the conductive layer 50 is formed not only on the polished surfaces 40U and 40D of the magnetic layer 40 but also on the surface therearound (for example, the first surface 10U and the second surface 10D of the core substrate 10). In FIG. 8, the example that the conductive layer 50 is formed on both sides of the core substrate 10 is illustrated; but the conductive layer 50 may be formed on only one side of the core substrate 10.

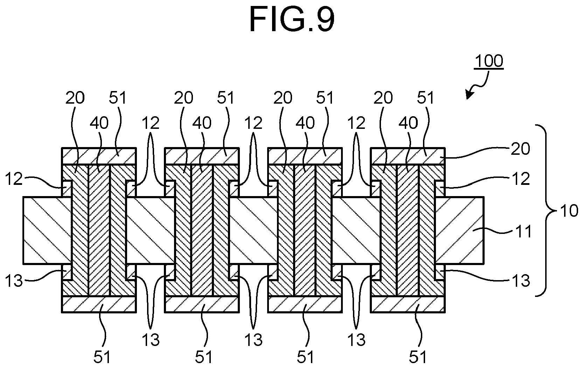

FIG. 9 is a schematic cross sectional view to explain the step (5) in the production method of the circuit board 100 according to one embodiment of the present invention. After the conductive layer 50 is formed, the step (5) may include removing a part of the conductive layer 50, the metal layers 12 and 13, and the plated layer 20 to form a patterned conductive layer 51 by a treatment such as etching, as illustrated in FIG. 9.

Illustrative examples of the method for forming the conductive layer 50 may include a plating method, a sputtering method, and a vapor deposition method. Among these, the plating method is preferable. In a preferable embodiment, the surface of the magnetic layer 40 (and the core substrate 10, as needed) is plated with a suitable method such as a semi-additive method or a full additive method, so that the patterned conductive layer 51 having an intended wiring pattern may be formed. Illustrative examples of the material of the conductive layer 50 may include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as the nickel-chromium alloy. Copper is still more preferably used.

Here, the example of the method to form the patterned conductive layer 51 will be explained in detail. A plated seed layer is formed on the polished surfaces 40U and 40D of the magnetic layer 40 by electroless plating. Next, after a mask pattern is formed as needed, an electroplated layer is formed on the plated seed layer thus formed by electroplating. Then, as needed, the mask pattern is removed, and then further an unnecessary plated seed layer is removed by a treatment such as etching, so that the patterned conductive layer 51 having an intended wiring pattern can be formed. After the patterned conductive layer 51 is formed, in order to enhance the adhesion strength of the patterned conductive layer 51, an annealing treatment may be carried out, as needed. The annealing treatment may be carried out, for example, by heating at 150°C to 200°C for the period of 20 minutes to 90 minutes.

The thickness of the patterned conductive layer 51 is preferably 1 um or more, more preferably 3 um or more, and still more preferably 5 um or more, and is preferably 70 um or less, more preferably 50 um or less, still more preferably 40 um or less, and especially preferably 10 µm or less.

By the method described above, the circuit board 100 including the magnetic layer 40 can be obtained. The magnetic layer 40 is obtained by curing the resin composition layer 31; thus, this includes the cured product of the resin composition. Therefore, the magnetic layer 40 can contain more magnetic powder (not illustrated in the drawing) so that this can have excellent magnetic properties. In addition, because the magnetic layer 40 has an improved polishing workability while containing a large amount of the magnetic powder, the polishing of the magnetic layer 40 at the step (3) can be performed quickly and smoothly. Therefore, the circuit board 100 can be produced quickly and stably.

### [13. Inductor Part]

The inductor part according to one embodiment of the present invention includes the circuit board described above. The inductor part usually has an inductor pattern that is formed of a conductor at least in part of the circumference of the magnetic layer described above. As for the inductor part, for example, the one that is described in Japanese Patent Application Laid-open No. 2016-197624 may be used.

The inductor part can be used as the wiring board to mount an electronic part such as a semiconductor chip, and can also be used as a (multilayered) printed wiring board that uses this wiring board as an inner layer substrate. In addition, this can be used as a chip inductor part obtained by dicing the wiring board, and can also be used as a printed wiring board that is surface-mounted with the chip inductor part.

In addition, by using this wiring board, semiconductor devices with various embodiments may be produced. The semiconductor device including the wiring board can be suitably used in electric products (for example, a computer, a mobile phone, a digital camera, and a television), vehicles (for example, a motor bike, an automobile, a train, a marine ship, and an airplane), and so forth.

### <EXAMPLES>

Hereinafter, the present invention will be specifically described by Examples. The present invention is not limited to these Examples. In the description below, "part" and "%" that describe quantity mean "part by mass" and "% by mass", respectively, unless otherwise specifically mentioned. Unless otherwise specifically mentioned, the following operations were performed at normal temperature and normal pressure (23°C and 1 atm). In addition, the volume content was determined by calculation using mass and specific gravity. Solvents were not included in the calculation of the volume content. In the explanation described hereinafter, "MEK" means "methyl ethyl ketone" unless otherwise specifically mentioned.

### <Example 1: Production of Magnetic Varnish 1>

2.6 parts by mass of epoxy resin ("ZX-1059" manufactured by Nippon Steel Chemical & Materials Co., ltd.; a mixture of bisphenol A type epoxy resin and bisphenol F type epoxy resin; epoxy equivalent of about 165 g/eq.; specific gravity of 1.18 g/cm³), 2.9 parts by mass of phenolic resin containing a triazine skeleton ("LA-7054" manufactured by DIC Corp.; hydroxyl equivalent of about 125 g/eq.; specific gravity of solid portion 1.31 g/cm³, MEK solution with 60% solid content), 2.2 parts by mass of phenoxy resin ("YX7553BH30" manufactured by Mitsubishi Chemical Corp.; specific gravity of solid portion 1.18 g/cm³; 1/1 MEK/cyclohexanone solution with 30% solid content), 0.6 parts by mass of dispersant ("ED-152" manufactured by Kusumoto Chemicals, Ltd.; polyether phosphate ester, specific gravity of 1.00 g/cm³), 3.5 parts by mass of solvent (cyclohexanone), 0.02 parts by mass of imidazole type curing facilitator ("2E4MZ" manufactured by Shikoku Chemicals Corp.; 2-ethyl-4-methylimidazole; specific gravity of 0.97 g/cm³), 24.3 parts by mass of magnetic powder a1 having an average particle diameter of less than 1 um ("M001" manufactured by Powdertech, Inc.; Fe-Mn type ferrite, average particle diameter of 0.2 um, specific gravity of 5.1 m²/g, ratio of the filler having a particle diameter of less than 1 um: 86.1%), and 65.6 parts by mass of magnetic powder A1 having an average particle diameter of 1 um or more ("AW2-08PF3F" manufactured by Epson Atmix Corp.; Fe-Cr-Si type alloy (amorphous); average particle diameter of 3.0 µm, specific gravity of 6.9 m²/g; ratio of the filler having a particle diameter of less than 1 um: 1.5%).

### <Example 2: Production of Magnetic Varnish 2>

The amount of the magnetic powder a1 having an average particle diameter of less than 1 um ("M001" manufactured by Powdertech, Inc.) was changed from 24.3 parts by mass to 17.8 parts by mass. The amount of the magnetic powder A1 having an average particle diameter of 1 um or more ("AW2-08PF3F" manufactured by Epson Atmix Corp.) was changed from 65.6 parts by mass to 74.5 parts by mass. A magnetic varnish 2 was produced in the same way as in Example 1 except for the aformentioned matters.

### <Example 3: Production of Magnetic Varnish 3>

The amount of the magnetic powder a1 having an average particle diameter of less than 1 um ("M001" manufactured by Powdertech, Inc.) was changed from 24.3 parts by mass to 14.6 parts by mass. The amount of the magnetic powder A1 having an average particle diameter of 1 um or more ("AW2-08PF3F" manufactured by Epson Atmix Corp.) was changed from 65.6 parts by mass to 78.6 parts by mass. A magnetic varnish 3 was produced in the same way as in Example 1 except for the aformentioned matters.

### <Example 4: Production of Magnetic Varnish 4>

The amount of the magnetic powder a1 having an average particle diameter of less than 1 um ("M001" manufactured by Powdertech, Inc.) was changed from 24.3 parts by mass to 34.8 parts by mass. The amount of the magnetic powder A1 having an average particle diameter of 1 um or more ("AW2-08PF3F" manufactured by Epson Atmix Corp.) was changed from 65.6 parts by mass to 51.0 parts by mass. A magnetic varnish 4 was produced in the same way as in Example 1 except for the aformentioned matters.

### <Example 5: Production of Magnetic Varnish 5>

The amount of the magnetic powder a1 having an average particle diameter of less than 1 um ("M001" manufactured by Powdertech, Inc.) was changed from 24.3 parts by mass to 13.0 parts by mass. The amount of the magnetic powder A1 having an average particle diameter of 1 um or more ("AW2-08PF3F" manufactured by Epson Atmix Corp.) was changed from 65.6 parts by mass to 81.0 parts by mass. A magnetic varnish 5 was produced in the same way as in Example 1 except for the aformentioned matters.

### <Example 6: Production of Magnetic Varnish 6>

24.3 parts by mass of the magnetic powder a1 having an average particle diameter of less than 1 um ("M001" manufactured by Powdertech, Inc.) was replaced with 26.0 parts by mass of magnetic powder a3 having an average particle diameter of less than 1 um ("MZ03S" manufactured by Powdertech, Inc., Fe-Zn-Mn type ferrite, average particle diameter of 0.5 um, specific gravity of 5.3 m²/g, ratio of the filler having a particle diameter of less than 1 um: 86.1%). The amount of the magnetic powder A1 having an average particle diameter of 1 um or more ("AW2-08PF3F" manufactured by Epson Atmix Corp.) was changed from 65.6 parts by weight to 105.0 parts by mass. A magnetic varnish 6 was produced in the same way as in Example 1 except for the aformentioned matters.

### <Example 7: Production of Magnetic Varnish 7>

24.3 parts by mass of the magnetic powder a1 having an average particle diameter of less than 1 um ("M001" manufactured by Powdertech, Inc.) was replaced with 30.0 parts by mass of the magnetic powder a3 having an average particle diameter of less than 1 um ("MZ03S" manufactured by Powdertech, Inc.). In addition, 65.6 parts by mass of the magnetic powder A1 having an average particle diameter of 1 um or more ("AW2-08PF3F" manufactured by Epson Atmix Corp.) was replaced with 100.0 parts by mass of magnetic powder A2 having an average particle diameter of 1 um or more ("MA-RCO-24" manufactured by Dowa Electronics Co. Ltd.; Fe-Ni type alloy; average particle diameter of 3.0 µm, specific gravity of 8.0 m²/g, ratio of the filler having a particle diameter of less than 1 µm: 4.3%). A magnetic varnish 7 was produced in the same way as in Example 1 except for the aformentioned matters.

### <Example 8: Production of Magnetic Varnish 8>

24.3 parts by mass of the magnetic powder a1 having an average particle diameter of less than 1 um ("M001" manufactured by Powdertech, Inc.) was replaced with 35 parts by mass of magnetic powder a2 having an average particle diameter of less than 1 um (fine powder alloy manufactured by JFE Mineral & Alloy Co., Ltd.; Fe-Cr-Si type alloy, average particle diameter of 0.7 um, specific gravity of 6.9 m²/g, ratio of the filler having a particle diameter of less than 1 um: 72.4%). The amount of the magnetic powder A1 having an average particle diameter of 1 um or more ("AW2-08PF3F" manufactured by Epson Atmix Corp.) was changed from 65.6 parts by mass to 90.0 parts by mass. A magnetic varnish 8 was produced in the same way as in Example 1 except for the aformentioned matters.

### <Example 9: Production of Magnetic Varnish 9>

24.3 parts by mass of the magnetic powder a1 having an average particle diameter of less than 1 um ("M001" manufactured by Powdertech, Inc.) was replaced with 19.0 parts by mass of magnetic powder a2 having an average particle diameter of less than 1 um (fine powder alloy manufactured by JFE Mineral & Alloy Co., Ltd.; Fe-Cr-Si type alloy). In addition, 65.6 parts by mass of the magnetic powder A1 having an average particle diameter of 1 um or more ("AW2-08PF3F" manufactured by Epson Atmix Corp.) was replaced with 87.0 parts by mass of the magnetic powder A2 having an average particle diameter of 1 um or more ("MA-RCO-24" manufactured by Dowa Electronics Co. Ltd.). A magnetic varnish 9 was produced in the same way as in Example 1 except for the aformentioned matters.

### <Example 10: Production of Magnetic Varnish 10>

24.3 parts by mass of the magnetic powder a1 having an average particle diameter of less than 1 um ("M001" manufactured by Powdertech, Inc.) was replaced with 10.0 parts by mass of the magnetic powder a3 having an average particle diameter of less than 1 um ("MZ03S" manufactured by Powdertech, Inc.). In addition, 65.6 parts by mass of the magnetic powder A1 having an average particle diameter of 1 um or more ("AW2-08PF3F" manufactured by Epson Atmix Corp.) was replaced with 40.0 parts by mass of magnetic powder A3 having an average particle diameter of 1 um or more ("M05S" manufactured by Powdertech, Inc.; Fe-Mn type ferrite, average particle diameter of 3.0 µm, specific gravity of 5.0 m²/g, the ratio of filler having a particle diameter of less than 1 µm: 1.20). A magnetic varnish 10 was produced in the same way as in Example 1 except for the aformentioned matters.

### <Comparative Example 1: Production of Magnetic Varnish 11>

The amount of the magnetic powder a1 having an average particle diameter of less than 1 um ("M001" manufactured by Powdertech, Inc.) was changed from 24.3 parts by mass to 43.0 parts by mass. The amount of the magnetic powder A1 having an average particle diameter of 1 um or more ("AW2-08PF3F" manufactured by Epson Atmix Corp.) was changed from 65.6 parts by mass to 40.0 parts by mass. A magnetic varnish 11 was produced in the same way as in Example 1 except for the aformentioned matters.

### <Comparative Example 2: Production of Magnetic Varnish 12>

The amount of the magnetic powder a1 having an average particle diameter of less than 1 um ("M001" manufactured by Powdertech, Inc.) was changed from 24.3 parts by mass to 57.5 parts by mass. The amount of the magnetic powder A1 having an average particle diameter of 1 um or more ("AW2-08PF3F" manufactured by Epson Atmix Corp.) was changed from 65.6 parts by mass to 20.4 parts by mass. A magnetic varnish 12 was produced in the same way as in Example 1 except for the aformentioned matters.

### <Comparative Example 3: Production of Magnetic Varnish 13>

The amount of the magnetic powder a1 having an average particle diameter of less than 1 um ("M001" manufactured by Powdertech, Inc.) was changed from 24.3 parts by mass to 6.5 parts by mass. The amount of the magnetic powder A1 having an average particle diameter of 1 um or more ("AW2-08PF3F" manufactured by Epson Atmix Corp.) was changed from 65.6 parts by mass to 89.9 parts by mass. A magnetic varnish 13 was produced in the same way as in Example 1 except for the aformentioned matters.

### <Production of Resin Sheet>

A polyethylene terephthalate film ("Lumirror R80" manufactured by Toray Industries, Inc.; thickness of 38 µm, softening point of 130°C) that is treated with an alkyd resin type releasing agent ("AL-5", manufactured by Lintec Inc.) was prepared as the support. Each of the resin varnishes produced in Examples and Comparative Examples was applied onto the support with a die coater such that the thickness of the resin composition layer after drying was 100 um; and then, this was dried at 65°C to 115°C (average 100°C) for 7 minutes to obtain a resin sheet.

### <Measurement of Relative Magnetic Permeability and Magnetic Loss>

The resin sheet was cut into 200 mm squares. The cut resin sheet (200 mm squares) was laminated using a batch-type vacuum-pressure laminator ("CVP700" manufactured by Nikko-Materials Co., Ltd.; two-stage build-up laminator) onto one surface of a polyimide film ("Iupilex 25S" manufactured by UBE Corp.; thickness of 25 um, 240 mm square) such that the resin composition layer was in contact with the center of the smooth surface of the polyimide film. Lamination was carried out by depressurizing over 30 seconds to bring the pressure to 13 hPa or less, followed by pressing to bond with the pressure of 0.74 MPa and the temperature of 100°C for 30 seconds. With this, a multi-layer film having a layered structure of support/resin composition layer/polyimide film was obtained.

After the support was removed, the resin composition layer was heated at 190°C for 90 minutes to be thermally cured. The polyimide film was then removed to obtain the sheet-shaped cured product of the resin composition. The sheet-shaped cured product thus prepared was cut to obtain an evaluation sample having a width of 5 mm and a length of 18 mm. The relative magnetic permeability (µ') and the magnetic loss (µ") of the evaluation sample were measured at room temperature of 23°C by the 3-turn coil method at a measurement frequency of 20 MHz by using Agilent Technologies ("HP8362B" manufactured by Agilent Technologies, Inc.). The magnetic loss was calculated from the formula [tand=µ"/µ'].

### <Measurement of Polishing Amount>

### (1) Surface Treatment of Inner Layer Circuit Board

A both-surface copper clad epoxy-impregnated glass cloth substrate ("R1515A" manufactured by Panasonic Corp.; thickness of the copper foil: 18 um, thickness of the substrate: 0.8 mm) formed with an inner layer circuit was prepared as an inner layer circuit board. Both sides of the inner layer circuit board were etched with an amount of 1 um using an etching agent ("CZ8101" manufactured by MEC Co., Ltd.) to roughen the copper surface.

### (2) Lamination of Resin Sheet

The resin sheet was cut into 100 mm squares. The resulting cut resin sheet was laminated onto one surface of the inner layer circuit board by using a batch-type vacuum-pressure laminator (two-stage build-up laminator, "CVP700" manufactured by Nikko-Materials Co., Ltd.) such that the resin composition layer was in contact with the center of the surface of the inner layer circuit board. Lamination was carried out by depressurizing over 30 seconds to bring the pressure to 13 hPa or less, followed by pressing to bond with the pressure of 0.74 MPa and the temperature of 100°C for 30 seconds.

### (3) Thermal Curing of Resin Composition

The support was removed from the resin sheet. Then, at 130°C for 30 minutes, followed by 190°C for 60 minutes, the resin composition layer was thermally cured to obtain a sample multilaysed body comprising a magnetic layer formed of the cured product of the resin composition and the inner layer circuit board.

### (4) Measurement of Thickness Before Polishing

The thickness (thickness before polishing) of the magnetic layer was measured using a micrometer.

### (5) Polishing Treatment of Magnetic Layer

The magnetic layer of the sample mulitilayered body was polished using a single-sided biaxial polishing machine ("NT-700IM" manufactured by Ishiihyoki Co., Ltd.). The polishing rolls were ceramic polishing rolls #800 manufactured by Ishiihyoki Co., Ltd. In all of Examples and Comparative Examples, polishing was performed under certain polishing conditions.

### (6) Calculation of Polishing Amount

The thickness (thickness after polishing) of the magnetic layer of the sample maulilayered body after polishing was measured using a micrometer. The amount of polishing was then calculated by subtracting the thickness after polishing from the thickness before polishing.

### [Results]

The results of Examples and Comparative Examples are summarized in Tables below. In the Tables, the abbreviations have the following meanings.

Mixing ratio (small diameter; vol%): the ratio (% by volume) of the magnetic powders having an average particle diameter of less than 1 um with respect to 100% by volume of the total of (A) the magnetic powders.

Ratio of small diameter powder (vol%): Percentage (% by volume) of (A-1) the small diameter magnetic powder with respect to 100% by volume of the total of (A) the magnetic powders.

**[Table 1]**

| **[Table 1. Results of Examples 1 to 7]** | | | | | | | |
|---|---|---|---|---|---|---|---|
| | Example | | | | | | |
| | 1 | 2 | 3 | 4 | 5 | 6 | 7 |
| (A) M001 | 24.3 | 17.8 | 14.6 | 34.8 | 13.0 | | |
| (A) fine powder alloy | | | | | | | |
| (A) MZ03S | | | | | | 26.0 | 30.0 |
| (A) AW02-08 PF3F | 65.6 | 74.5 | 78.6 | 51.0 | 81.0 | 105.0 | |
| (A) MA-RCO-24 | | | | | | | 100.0 |
| (A) MOSS | | | | | | | |
| (B-1) ZX-1059 | 2.6 | 2.6 | 2.6 | 2.6 | 2.6 | 2.6 | 2.6 |
| (B-2) LA-7054 | 2.9 | 2.9 | 2.9 | 2.9 | 2.9 | 2.9 | 2.9 |
| (C) YX7553BH30 | 2.2 | 2.2 | 2.2 | 2.2 | 2.2 | 2.2 | 2.2 |
| (D) ED-152 | 0.6 | 0.6 | 0.6 | 0.6 | 0.6 | 0.6 | 0.6 |
| (E) 2E4MZ | 0.02 | 0.02 | 0.02 | 0.02 | 0.02 | 0.02 | 0.02 |
| (G) cyclohexanone | 3.5 | 3.5 | 3.5 | 3.5 | 3.5 | 3.5 | 3.5 |
| Total amount of regent(part) | 101.7 | 104.1 | 105.0 | 97.6 | 105.8 | 142.8 | 141.8 |
| Magnetic powder (wt%) | 94.1 | 94.3 | 94.3 | 93.9 | 94.4 | 95.9 | 95.9 |
| Magnetic powder (vol%) | 75.3 | 75.3 | 75.3 | 75.2 | 75.3 | 81.1 | 79.5 |
| Mixing ratio (small diameter; vol %) | 33% | 24% | 20% | 48% | 18% | 24% | 30% |
| Ratio of small diameter powder (vol%) | 29.7% | 22.2% | 18.5% | 42.1% | 16.6% | 21.6% | 29.1% |
| thickness before polishing (µm) | 103 | 107 | 113 | 112 | 110 | 113 | 113 |
| thickness after polishing (µm) | 79 | 87 | 91 | 71 | 90 | 85 | 85 |
| polishing amount (µm) | 24 | 20 | 22 | 41 | 20 | 28 | 28 |
| | good | good | good | good | good | good | good |
| cracks and chips by polishing | good | good | good | good | good | good | good |
| Magnetic Permeability | 18 | 19 | 16 | 18 | 17 | 18 | 19 |
| Magnetic Loss | 0.032 | 0.04 | 0.04 | 0.032 | 0.026 | 0.032 | 0.034 |

**[Table 2]**

| **[Table 2. Results of Examples 8 to 10 and Comparative Examples 1 to 3]** | | | | | | |
|---|---|---|---|---|---|---|
| | Example | | | Comparative Example | | |
| | 8 | 9 | 10 | 1 | 2 | 3 |
| (A) M001 | | | | 43.0 | 57.5 | 6.5 |
| (A) fine powder alloy | 35.0 | 19.0 | | | | |
| (A) MZ03S | | | 10.0 | | | |
| (A) AW02-08 PF3F | 90.0 | | | 40.0 | 20.4 | 89.9 |
| (A) MA-RCO-24 | | 87.0 | | | | |
| (A) MOSS | | | 40.0 | | | |
| (B-1) ZX-1059 | 2.6 | 2.6 | 2.6 | 2.6 | 2.6 | 2.6 |
| (B-2) LA-7054 | 2.9 | 2.9 | 2.9 | 2.9 | 2.9 | 2.9 |
| (C) YX7553BH30 | 2.2 | 2.2 | 2.2 | 2.2 | 2.2 | 2.2 |
| (D) ED-152 | 0.6 | 0.6 | 0.6 | 0.6 | 0.6 | 0.6 |
| (E) 2E4MZ | 0.02 | 0.02 | 0.02 | 0.02 | 0.02 | 0.02 |
| (G) cyclohexanone | 3.5 | 3.5 | 3.5 | 3.5 | 3.5 | 3.5 |
| Total amount of regent(part) | 136.8 | 117.8 | 61.8 | 94.8 | 89.7 | 108.2 |
| Magnetic powder (wt%) | 95.7 | 95.0 | 89.9 | 93.6 | 93.3 | 94.5 |
| Magnetic powder (vol%) | 79.5 | 74.4 | 67.9 | 75.3 | 75.3 | 75.3 |
| Mixing ratio (small diameter;vol %) | 28% | 20% | 19% | 59% | 79% | 9% |
| Ratio of small diameter powder (vol%) | 21.4% | 18.1% | 16.9% | 51.6% | 68.5% | 9.0% |
| thickness before polishing (µm) | 107 | 109 | 112 | 115 | 112 | 118 |
| thickness after polishing (µm) | 85 | 87 | 73 | 57 | 41 | 105 |
| polishing amount (µm) | 22 | 22 | 39 | 58 | 71 | 13 |
| | good | good | good | good | good | not good |
| cracks and chips by polishing | good | good | good | not good | not good | good |
| Magnetic Permeability | 15 | 18 | 13 | 14 | 13 | 16 |
| Magnetic Loss | 0.016 | 0.03 | 0.016 | 0.03 | 0.022 | 0.038 |

### Reference Signs List

- 10: Core substrate
- 10U: First surface
- 10D: Second surface
- 11: Supporting substrate
- 12: Metal layer
- 13: Metal layer
- 14: Through hole
- 20: Plated layer
- 30: Resin Sheet
- 31: Resin composition layer
- 32: Support
- 40: Magnetic layer
- 40U: Polished surface
- 40D: Polished surface
- 50: Conductive layer
- 51: Patterned conductive layer
- 100: Circuit board

## Claims

1. A resin composition comprising (A) a magnetic powder and (B) a thermosetting resin, wherein
an amount of (A) the magnetic powder relative to 100% by volume of nonvolatile components in the resin composition is 65% or more by volume, and
(A) the magnetic powder comprises 10% or more by volume to 50% or less by volume of (A-1) a magnetic powder having a particle diameter of less than 1 µm.

2. The resin composition according to claim 1, wherein (B) the thermosetting resin comprises (B-1) an epoxy resin.

3. The resin composition according to claim 1, wherein the resin composition comprises (C) a thermoplastic resin.

4. The resin composition according to claim 1, wherein the resin composition is for filling of a through hole.

5. A resin sheet having a resin composition layer comprising the resin composition according to any one of claims 1 to 4.

6. The resin sheet according to claim 5, wherein the resin sheet comprises a support.

7. A method for producing a circuit board, the method comprising steps of:
laminating a substrate formed with a through hole and the resin sheet according to claim 5 to fill the through hole with a portion of the resin composition layer;
curing the resin composition layer to form a magnetic layer; and
polishing the magnetic layer, in this order.

8. A circuit board comprising:
a substrate formed with a through hole, and
a magnetic layer filled in the through hole, wherein
the magnetic layer comprises a cured product of the resin composition according to any one of claims 1 to 4.

9. An inductor part comprising the circuit board according to claim 8.
